(19) Europäisches Patentamt
European Patent Office
Office européen des brevets

(11) Publication number: **0 450 394 A2**

# (12) EUROPEAN PATENT APPLICATION

(21) Application number: **91104240.6**

(22) Date of filing: **19.03.91**

(51) Int. Cl.5: **H01L 39/24**, C23C 16/50, C23C 16/40

(30) Priority: **20.03.90 JP 72351/90**
**21.09.90 JP 252334/90**
**27.12.90 JP 407713/90**

(43) Date of publication of application:
**09.10.91 Bulletin 91/41**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Nakao, Hiroshi**
**1091-4-101, Aikou**
**Atsugi-shi, Kanagawa, 243(JP)**
Inventor: **Kimura, Takafumi**
**3-19-15, Hiratsuka**
**Hiratsuka-shi, Kanagawa, 254(JP)**
Inventor: **Yamawaki, Hideki**
**5-7-13, sakuradai**
**Isehara-shi, Kanagawa, 259-11(JP)**
Inventor: **Ihara, Masaru**
**2-2-55-302, Matsugaoka**
**Chigasaki-shi, Kanagawa, 253(JP)**

(74) Representative: **Schmidt-Evers, Jürgen, Dipl.-Ing. et al**
**Patentanwälte Mitscherlich, Gunschmann**
**Dr. Körber, Schmidt-Evers, Melzer, Dr. Schulz**
**Steinsdorfstrasse 10**
**W-8000 München 22(DE)**

## (54) Method and apparatus for forming superconductor layer.

(57) A method of forming a superconductor layer includes the steps of setting a substrate (1) within a deposition chamber (4), and forming an oxide superconductor layer on a surface of the substrate within the deposition chamber by halides of elements forming the oxide superconductor and plasma of oxidizer.

EP 0 450 394 A2

FIG.4A

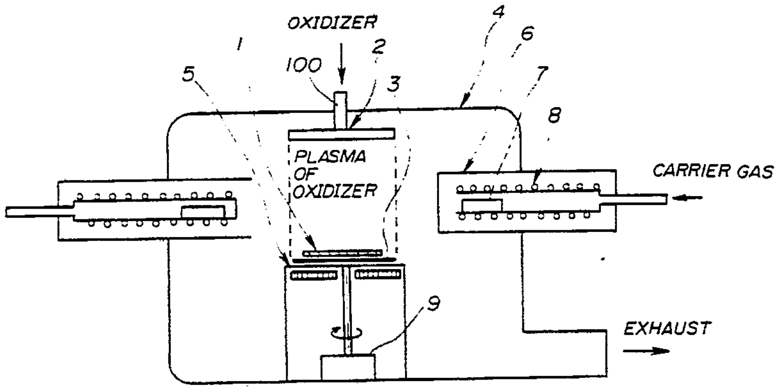
OXIDIZER
4
6
1
2
100
5
3
7
8
PLASMA
OF
OXIDIZER
CARRIER GAS
9
EXHAUST

## BACKGROUND OF THE INVENTION

The present invention generally relates to methods and apparatuses for forming superconductor layers, and more particularly to a method and an apparatus for forming a superconductor layer using a plasma chemical vapor deposition (CVD).

Recently, there are active research and development of high temperature superconductor materials in various fields. Since the high temperature superconductor material becomes superconductive at a relatively high temperature which is greater than or equal to a liquid nitrogen temperature (77K), the high temperature superconductor material can be applied to various applications such as semiconductor devices and circuit interconnections. Accordingly, there are also various demands on the high temperature superconductor material such as the realization of a method of forming a uniform high temperature superconductor layer having a satisfactory quality with a high efficiency.

Conventionally, the superconductor layer is formed by a sputtering, evaporation or the like. However, when a large number of superconductor layers are formed at the same time on relatively large areas, there are problems in that the thickness and quality of the superconductor layers become inconsistent and the production yield becomes poor.

In order to overcome the above described problems, the present inventors have previously proposed a CVD method which uses halide source material to form a superconductor layer in an European Patent Application No.88309324.7 filed October 16, 1988.

FIG.1 shows a cross sectional view of a CVD apparatus for forming a superconductor layer using the previously proposed CVD method. A susceptor 17 on which a substrate 1 is placed and a source chamber 15 which generates source gases are provided within a deposition chamber 18. Source materials 15a through 15d are placed within the source chamber 15, and a carrier gas is introduced into the source chamber 15. For example, the source materials 15a through 15d are $BiCl_3$, $SrI_2$, $CaI_2$ and CuI. The source materials 15a through 15d are respectively heated to appropriate temperatures by heaters 16 which heat regions of the source materials 15a through 15d. An oxidizer is introduced into the deposition chamber 18. For example, an oxygen gas is used as the oxidizer.

According to the previously proposed CVD method, it is possible to form a superconductor layer with a satisfactory crystal reproducibility when compared to the conventional method which uses sputtering, evaporation or the like.

However, the superconductor layer formed by the previously proposed CVD method is still unsatisfactory in terms of the surface smoothness and uniformity of the formed superconductor layer.

FIG.2 shows a data which is obtained by measuring the surface roughness of the superconductor layer which is formed on a substrate by the previously proposed CVD method. The measurement was made using a measuring device of a type having a needle which makes contact with the surface of the superconductor layer. In FIG.2, SS denotes the substrate surface. It may be seen from FIG.2 that the surface of the superconductor layer includes a height difference of approximately 2000 Å, and this superconductor layer is unsuited for use in a device.

In the Bi system superconductor, $BiCl_3$, $SrI_2$, $CaI_2$, CuI and the like are used as source materials, but in this case, it is necessary to heat the substrate to a range of 700 to 900 °C or greater.

In order to improve the surface smoothness and the uniformity of the superconductor layer and to decrease the deposition temperature, it may be considered effective to carry out the deposition under a low pressure. However, in an oxide superconductor, a quantity of oxygen required for the superconductor layer is not introduced when the oxygen pressure is low, and it becomes necessary to carry out an annealing for a relatively long time at a relatively high temperature (for example, one hour at 850 °C) within an oxidizer atmosphere such as oxygen gas. For this reason, there are problems in that the number of processes increases and sapphire cannot be used for the substrate.

## SUMMARY OF THE INVENTION

Accordingly, it is a general object of the present invention to provide a novel and useful method and apparatus for forming a superconductor layer, in which the problems described above are eliminated.

Another and more specific object of the present invention to provide a method of forming a superconductor layer comprising the steps of setting a substrate within a deposition chamber, and forming an oxide superconductor layer on a surface of the substrate within the deposition chamber by halides of elements forming the oxide superconductor and plasma of oxidizer. According to the method of the present invention, it is possible to form a superconductor layer having a satisfactory surface smoothness and uniformity at a relatively low temperature. Further, no annealing is required after formation of the superconductor layer.

Still another object of the present invention is to provide an apparatus for forming an oxide superconductor layer on a surface of a substrate, comprising a deposition chamber, a susceptor for supporting the substrate within the deposition chamber, oxidizer supplying means for supplying an oxidizer onto the substrate, plasma generating electrodes for applying a high frequency electric field on the oxidizer on the substrate so as to generate plasma of the oxidizer, a first heater for heating the substrate, and a plurality of cells for supplying halides of elements forming the oxide superconductor layer onto the substrate as source material gases, where the oxide superconductor layer is formed on the surface of the substrate within the deposition chamber by the halides of the elements forming the oxide superconductor and the oxidizer plasma. According to the apparatus of the present invention, it is possible to form a superconductor layer having a satisfactory surface smoothness and uniformity at a relatively low temperature.

Other objects and further features of the present invention will be apparent from the following detailed description when read in conjunction with the accompanying drawings.

## BRIEF DESCRIPTION OF THE DRAWINGS

FIG.1 is a cross sectional view generally showing an example of a conventional CVD apparatus;

FIG.2 shows a measured surface roughness of a superconductor layer formed by a previously proposed CVD method;

FIG.3 is a diagram for explaining an operating principle of the present invention;

FIGS.4A and 4B respectively are a cross sectional view and a plan view showing a first embodiment of an apparatus according to the present invention;

FIG.5 shows a measured surface roughness of a superconductor layer formed by the first embodiment;

FIG.6 shows an X-ray diffraction of the superconductor layer formed by the first embodiment;

FIG.7 shows a resistance versus temperature characteristic of the superconductor layer which is formed by the first embodiment;

FIG.8 is a cross sectional view showing a cell structure of a second embodiment of the apparatus according to the present invention;

FIG.9 is a cross sectional view showing a cell structure of a third embodiment of the apparatus according to the present invention;

FIG.10A is a cross sectional view showing a cell structure of a fourth embodiment of the apparatus according to the present invention;

FIG.10B is a cross sectional view showing an essential part of the cell structure shown in FIG.10A on an enlarged scale;

FIG.11 is a cross sectional view showing a shutter structure of a fifth embodiment of the apparatus according to the present invention;

FIG.12 is a cross sectional view showing a shutter structure of a sixth embodiment of the apparatus according to the present invention;

FIG.13 shows a growth (deposition) rate versus in-plane distance characteristics obtained in the fifth and sixth embodiments in comparison with a characteristic obtained by use of a conventional shutter

FIG.14 shows a resistivity versus process temperature characteristic for explaining dependency of a Bi system superconductor layer on the process temperature;

FIG.15 shows a maximum deviation versus process temperature characteristic for explaining the dependency of the Bi system superconductor layer on the process temperature;

FIG.16 is a cross sectional view showing a seventh embodiment of the apparatus according to the present invention;

FIG. 17 shows a resistance versus temperature characteristic of a superconductor layer formed by the seventh embodiment;

FIGS.18A and 18B respectively are a cross sectional view and a plan view showing an eighth embodiment of the apparatus according to the present invention;

FIG. 19 is a plan view showing a ninth embodiment of the apparatus according to the present invention;

FIG.20 is a cross sectional view showing a tenth embodiment of the apparatus according to the present invention;

FIG.21 is a cross sectional view showing an eleventh embodiment of the apparatus according to the present invention;

FIG.22 shows a resistance versus temperature characteristic of a layer which is formed by the eleventh embodiment;

FIG.23 shows the effects of a substrate temperature at which the plasma is stopped on the (002) peak intensity of the X-ray diffraction of the (2212)-Bi system superconductor layer and the superconducting temperature $T_c$;

FIG.24A is a cross sectional view showing a cell structure of a thirteenth embodiment of the apparatus according to the present invention;

FIG.24B is a cross sectional view showing an essential part of the cell structure shown in FIG.24A on an enlarged scale;

FIG.25 shows a control part for controlling a pressure adjusting needle shown in FIGS.24A and 24B;

FIG.26A is a plan view showing an inner tube of a cell and a cell heater;

FIG.26B is a cross sectional view showing a part of the structure shown in FIG.26A;

FIG.27A is a plan view showing an essential part of a cell structure used in a fourteenth embodiment of the apparatus according to the present invention;

FIG.27B is a cross sectional view showing a part of the structure shown in FIG.27A;

FIGS.28A through 28D are cross sectional views for explaining the formation of a heater;

FIGS.29A through 29C are cross sectional views for explaining a fourth embodiment of the method according to the present invention; and

FIG.30 shows a resistance versus temperature characteristic of a superconductor layer which is formed by the fourth embodiment of the method.

DESCRIPTION OF THE PREFERRED EMBODIMENTS

First, a description will be given of an operating principle of the present invention, by referring to FIG.3. In FIG.3, an upper electrode 2 is positioned above a substrate 1 which is placed on a susceptor 3. A high frequency electric field is applied between the upper electrode 2 and the susceptor 3 or a lower electrode (not shown) which is positioned below the susceptor 3. Source material gases and an oxidizer are introduced above the substrate 1, and the pressure is maintained low so as to permit generation of plasma of oxidizer (hereinafter simply referred to as oxidizer plasma).

In the present invention, the deposition is carried out under a low pressure so as to eliminate uneven flow of source material gases and to improve the surface smoothness and uniformity of a superconductor layer which is formed.

When the superconductor layer is simply formed under the low pressure, the lack of oxygen occurs and the formed layer does not become superconductive. For this reason, the present invention generates the oxidizer plasma. Actually, the plasma of not only the oxidizer but also the plasmas of the source material gases are also generated. When the oxidizer plasma is generated, the oxidation becomes more active and improved due to the generation of radicals and it is possible to introduce sufficient oxygen even under the low pressure.

According to the present invention, a superconductor layer having satisfactory surface smoothness and uniformity can be formed at a relatively low temperature, and there is no need to carry out an annealing after formation of the layer. The halide in general is a stable and uneasily decomposed material, and this tendency becomes stronger at low temperatures. For this reason, when the plasma of the halide is generated, it is possible to improve the reaction efficiency in vapor. By generating the plasmas of the halide and the oxidizer, it is possible to enhance the reaction in vapor and more easily form the superconductor layer.

First, a description will be given of a first embodiment of an apparatus according to the present invention which uses a first embodiment of a method according to the present invention. FIGS.4A and 4B respectively are a cross sectional view and a plan view of the first embodiment of the apparatus. In FIGS.4A and 4B, a substrate 1 is placed on a susceptor 3 within a deposition chamber 4. An upper electrode 2 is located above the substrate, and the susceptor 3 is used as a lower electrode. The substrate 1 is heated by a substrate heater 5 via the susceptor 3. The susceptor 3 is rotatable supported on a rotary mechanism 9. A plurality of cells 6 connect to the deposition chamber 4, and a cell heater 8 is provided on each of the cells 6. Source boats 7 (7a through 7d) are provided within the respective cells 6.

As shown in FIG.4A, the substrate heater 5 heats the substrate 1 within the deposition chamber 4 which is maintained at a low pressure. In addition, a high frequency electric field is applied between the upper electrode 2 and the susceptor 3 (that is, lower electrode) so as to deposit an oxide superconductor in a state where the oxidizer plasma is generated. The source materials are placed on the source boats 7 (7a through 7d) within the cells 6 and are heated by the respective cell heaters 8. The evaporated source materials are transported by a carrier gas and supplied onto the substrate 1 as source material gases. The oxidizer is supplied onto the substrate 1 via a pipe 100 which is provided at a central part of the upper electrode 2. The oxidizer may be supplied via one or a plurality of pipes 100. When a plurality of pipes 100 are provided, it is possible to more evenly supply the oxidizer in the form of a shower.

In this embodiment, the oxide superconductor which is deposited is an oxide of Bi, Sr, Ca and Cu, and the heating temperatures of the source materials and the cells 6 are as follows.

| | |
|---|---|
| $BiCl_3$ | 100 to 300°C |
| $SrI_2$ | 750 to 1200°C |
| $CaI_2$ | 750 to 1200°C |
| CuI | 350 to 600°C |

For example, He gas is used as the carrier gas which is introduced into each of the cells 6, and the He gas is supplied at a flow rate in the range of 5 to 1000 cc/min. The inside of the deposition chamber 4 is maintained to a low pressure during the deposition so as to permit the generation of the oxidizer plasma. This low pressure is in the range of $10^{-3}$ to $10^{2}$ Torr, and desirably within the range of $10^{-2}$ to 10 Torr. $O_2$ and $H_2O$ are used as the oxidizer. The $O_2$ is supplied at a rate in the range of 5 to 2000 cc/min, and the $H_2O$ is supplied by bubbling the He gas into pure water which is adjusted to a temperature ranging from room temperature to 100°C at a rate of 10 to 1000 cc/min and introducing the humidified He gas into the deposition chamber 4.

For example, the substrate 1 may be made of MgO, $Al_2O_3$, $SrTiO_3$ and the like. In this embodiment, the (001) surface of MgO or the (1102) surface of $Al_2O_3$ (sapphire) is used for the substrate 1, and the substrate 1 is heated to approximately 670°C during the deposition. However, the temperature of the substrate 1 may be varied appropriately within the range of 500 to 900°C. The high frequency electric field which is applied to the oxidizer atmosphere is in the range of 20 to 500 W, and the frequency is 13.56 MHz.

Under the conditions described above, a superconductor layer having a thickness of 500 Å ± 25 Å was obtained by a deposition of three hours.

FIG.5 shows the surface roughness of the superconductor layer which is formed by this embodiment. The same device used to obtain the data shown in FIG.2 was used to obtain the data shown in FIG.5. As may be seen from FIG.5, the surface smoothness of the superconductor layer is considerably improved compared to that of the conventional superconductor layer shown in FIG.2.

FIG.6 shows an X-ray diffraction of the superconductor layer which is formed by this embodiment. The result shown in FIG.6 was obtained using the substrate 1 which is made of MgO, and no annealing was made after formation of the layer. In FIG.6, peaks corresponding to the (2212) phase Bi system superconductor appear and the superconduction occurs in a vicinity of 80K, and it was confirmed that the formed layer is superconductive.

FIG.7 shows a resistance versus temperature characteristic of the superconductor layer which is formed by this embodiment. The layer formed on the (1102) surface of the $Al_2O_3$ (sapphire) substrate 1 shows a zero resistance in a vicinity of 46 K, while the layer formed on the (001) surface of the MgO substrate 1 shows a zero resistance in a vicinity of 70 K. In either case where the $Al_2O_3$ substrate 1 or the MgO substrate 1 is used, no annealing was made after formation of the layer, but the superconductive characteristic was still obtainable.

In this embodiment, the oxidizer is supplied in a direction approximately perpendicular to the surface of the substrate 1, and the source material gases are supplied in directions approximately parallel to the surface of the substrate 1. However, the directions in which the oxidizer and the source material gases are supplied is not limited to those of this embodiment. In addition, the oxidizer plasma may be generated before the source material gases are supplied or in a state where the oxidizer and the source material gases are supplied onto the substrate 1. In this embodiment, the plasmas of the source material gases are also generated.

Therefore, the surface smoothness and the uniformity of the superconductor layer formed by this embodiment are improved. Furthermore, the superconductor layer can be formed at a relatively low temperature, and no annealing is necessary after formation of the layer.

The source materials used are not limited to those used in this embodiment, and halide of an element forming the superconductor layer may be used as the source material. If a BiSrCaCuO system superconductor layer is to be formed, the following source materials may be used.

Bismuth Source Material:

Bismuth Chloride, Bismuth Bromide, Bismuth Iodide

Strontium Source Material:

Strontium Iodide, Strontium Chloride, Strontium Bromide

Calcium Source Material:

Calcium Iodide, Calcium Chloride, Calcium Bromide

Copper Source Material:

Copper Iodide, Copper Chloride, Copper Bromide

FIG.8 shows a cell structure of a second embodiment of the apparatus according to the present invention. In FIG.8, an inner tube 6a which accommodates the source boat 7 is provided within the cell 6. A wire made of platinum, for example, is wound on the outer periphery of the inner tube 6a and forms the cell heater 8. In addition, an outlet A for the material gas located at a tip end of the inner tube 6a has a diameter smaller than that of the inner tube 6a.

According to this embodiment, the pressure within the inner tube 6a becomes high, so that it is possible to prevent a reverse flow of the gas from the deposition chamber 4. The reverse flow of the oxidizer atmosphere in particular is prevented, and it is possible to prevent deterioration or oxidation of the source material.

FIG.9 shows a cell structure of a third embodiment of the apparatus according to the present invention. In FIG.9, the cell 6 has a structure which is basically the same as that shown in FIG.8. However, the cell heater 8 is provided even at the tip end part of the cell 6.

According to this embodiment, the part of the cell 6 in the vicinity of the outlet A is also sufficiently heated by the cell heater 8. As a result, it is possible to prevent the source material gas from liquefying or solidifying in the vicinity of the outlet A, and the density of the gas can be controlled with ease.

FIG.10A shows a cell structure of a fourth embodiment of the apparatus according to the present invention, and FIG.10B shows a part of the cell structure shown in FIG. 10A on an enlarged scale. In FIGS.10A and 10B, the cell 6 has a two-tube structure and includes two inner tubers 6a and 6b. The carrier gas is introduced into the inner tube 6a via a carrier gas introducing pipe 10b, while an inert gas such as He gas is introduced into a space between the inner tubes 6a and 6b via an inert gas introducing pipe 10a.

According to this embodiment, the source material gas is output via the outlet A in a state where the source material gas is covered by the inert gas, as shown on the enlarged scale in FIG.10B. Since the outlet A of the cell 6 is adjacent to the deposition chamber 4, the source material gas may be oxidized by the oxidizer within the deposition chamber 4 and the oxidized source material may be deposited at the outlet A. However, in this embodiment, the source material gas will not easily mix with the oxidizer in the vicinity of the outlet A because the source material gas is covered by the inert gas. As a result, it is possible to prevent deposition of the oxidized source material at the outlet A.

On the other hand, the control of the layer forming process can be improved by providing a shutter in front of the cell 6 so as to control the output of the source material gas. Hence, a description will now be given of embodiments of the apparatus provided with shutters.

FIG.11 shows a shutter structure of a fifth embodiment of the apparatus according to the present invention. In this embodiment, a shutter cooling line 14 is provided to circulate a coolant within a shutter 12. For example, cooling water, cooling oil, cooling nitrogen or the like is used as the coolant. Accordingly, when the shutter 12 is closed to cut off the supply of the source material gas, the source material 11 leaking from the cell 6 is blocked by the closed shutter 12 and is prevented from scattering into other regions.

FIG. 12 shows a shutter structure of a sixth embodiment of the apparatus according to the present invention. In this embodiment, a pressure reducing line 15 is provided on the shutter 12 to suck at a front part of the shutter 12. Accordingly, when the shutter 12 is closed to cut off the supply of the source material gas, the source material 11 leaking from the cell 6 is sucked into the pressure reducing line 15 and prevented from scattering into other regions.

FIG.13 shows a growth (deposition) rate versus in-plane distance characteristics obtained in the fifth and sixth embodiments in comparison with the characteristic obtained by use of a conventional shutter. When the conventional shutter is used, a deposition of 20 Å/min was confirmed even when the shutter is closed. On the other hand, virtually no deposition was confirmed when the shutters of the fifth and sixth embodiments are closed. In addition, since there is no deposition caused by the source material gas which passes around the shutter 12, it was confirmed that the in-plane distribution is uniform during the formation of the layer.

The Bi system high temperature superconductor layer is more stable compared to the Y system high temperature superconductor layer, and the temperature at which the superconductivity is obtained is 100K or higher. In addition, the poisonous character of the Bi system high temperature superconductor layer is negligible when compared to that of the Tl system superconductor layer. The superconductor layer can be formed on substrates which are made of MgO, $SrTiO_3$ and the like, and the Bi system superconductor layer is also formed on the substrates which are made of such materials. However, the substrates which are made of such materials are not only expensive, but the crystal properties thereof are poor. Moreover, it is difficult to form a relatively large substrate made of such materials.

On the other hand, sapphire is conventionally used as a substrate on which a semiconductor layer is deposited, and the so-called silicon-on-sapphire (SOS) structure is well known. Hence, an inexpensive sapphire substrate having a relatively large area and a satisfactory quality can be obtained with ease, and there is a demand to form the Bi system superconductor layer on the sapphire substrate. Furthermore, the sapphire substrate is desirable for use when forming the Bi system superconductor layer because the crystal properties of sapphire are fine and the lattice mismatch with the Bi system superconductor is approximately 6% and small.

But when forming the Bi system superconductor layer by the conventional CVD (for example, the method proposed in European Patent Application No.88309324.7) using halides as the source materials, the range of the deposition temperature becomes approximately 750 to 850° C. But in such a temperature range, it was found that the sapphire substrate and the layer formed thereof react. It was also found that this phenomenon similarly occurs when the substrate is made of an alumina material.

Accordingly, the present inventors studied the conditions under which alumina (sapphire) and Bi system superconductor do not react, more particularly, the temperature range in which the alumina (sapphire) and the Bi system superconductor do not react. In addition, superconductor layers were formed at various temperatures.

FIGS.14 and 15 respectively show the dependency of the Bi system superconductor layer on the temperature of the thermal process when the sapphire substrate is used.

FIG. 14 shows the resistivity of a Bi system superconductor layer at room temperature when the superconductor layer is formed using a sapphire substrate, carrying out a plasma CVD at 67° C using the method of the first embodiment and thereafter carrying out annealing at various annealing temperatures. As may be seen from FIG.14, the resistivity sharply increases at annealing temperatures greater than approximately 700° C. Generally, a layer is superconductive when the resistivity is in the range of 20 to 30 mΩcm or less. Hence, FIG.14 shows that the quality of the layer deteriorates at annealing temperatures over 700° C.

FIG. 15 shows the maximum deviation of the exposed surface of the sapphire substrate when the Bi system superconductor layer is formed on the sapphire substrate under the same conditions as in FIG.14 but later subjected to an etching using hydrochloric acid and sulfuric acid so as to remove the layer. The surface roughness was measured using the same device used to obtain the data shown in FIG.5. As may be seen from FIG.15, the surface roughness becomes notable at annealing temperatures greater than approximately 700° C, and the solid phase reaction between the formed layer and the sapphire substrate was confirmed.

From FIGS.14 and 15, it was found desirable to form the superconductor layer by the plasma CVD at a deposition temperature of 700° C or less so that the alumina and Bi system superconductor do not react.

Next, a description will be given of a seventh embodiment of the apparatus according to the present invention, by referring to FIG.16. In FIG. 16, those parts which are the same as those corresponding parts in FIGS.4A and 4B are designated by the same reference numerals, and a description thereof will be omitted.

The evaporated source materials are transported by the carrier gas, and is supplied onto the substrate 1 as the source material gases under the control of shutters 22 which are opened and closed. In this embodiment, the (1102) surface of $Al_2O_3$ (sapphire) is used as the substrate 1, and the substrate 1 is heated to approximately 580° C during the formation of the superconductor layer. However, the temperature of the substrate 1 may be appropriately changed under the temperature of 700° C and desirably within the range of 500 to 700° C. The other conditions are the same as those of the first embodiment.

A superconductor layer having a thickness of approximately 700 Å was formed in six hours. No annealing is carried out after the formation of the superconductor layer.

The resistivity of the superconductor layer formed in this embodiment was measured to be 0.5 to 10 mΩcm which is acceptable as a superconductor. FIG.17 shows a resistance versus temperature characteristic of the superconductor layer which is formed in this embodiment. It may be seen from FIG.17 that the resistance becomes zero in a vicinity of 70K.

According to this embodiment, it is possible to form a superconductor layer having satisfactory characteristics even when a sapphire substrate is used.

If a BiSrCaCuO system superconductor layer is to be formed, the source materials described above may be used.

Next, a description will be given of an eighth embodiment of the apparatus according to the present invention, by referring to FIGS.18A and 18B. In FIGS.18A and 18B, those parts which are the same as those corresponding parts in FIG.16 are designated by the same reference numerals, and a description thereof will be omitted.

In this embodiment, a cover 21 is provided between the substrate 1 and the shutters 22, in addition to the structure employed in the seventh embodiment. Windows 21a are formed in the cover 21.

According to this embodiment, it is possible to prevent the source material gas from scattering onto the substrate 1 from the cells 6 and deteriorating the quality of the superconductor layer which is to be formed when the shutters 22 are closed. In addition, the deposition region is restricted by the provision of the cover 21. For this reason, it is possible to increase the gas density within the deposition region and reduce the quantity of the source materials used.

Next, a description will be given of a ninth embodiment of the apparatus according to the present invention, by referring to FIG.19. In FIG.19, those parts which are the same as those corresponding parts in FIG.16 are designated by the same reference numerals, and a description thereof will be omitted.

In this embodiment, shutters 23 function as parts of the cover 21. In other words, instead of providing the shutters 22 immediately in front of the respective cells 6, the shutters 23 are provided at positions which are separated by a predetermined distance from the respective cells 6 in order to restrict the deposition region. According to this embodiment, it is also possible to form a superconductor layer having a satisfactory quality, similarly as in the case of the eighth embodiment.

When the shutters 22 or 23 are closed, the radiation heat from the susceptor 3 is blocked by the closed shutters 22 or 23. However, the cells 6 are heated by the radiation heat immediately after the shutters 22 or 23 are opened. But in order to form a superconductor layer having a high quality, it is necessary to maintain the tip end temperature of the cells 6 constant and to suppress the temperature change of the cells 6 so that the stable supply of the source materials can be ensured. Hence, a description will now be given of an embodiment which is provided with a heater means on the shutter.

FIG.20 shows a tenth embodiment of the apparatus according to the present invention. In FIG.20, those parts which are the same as those corresponding parts in FIG.16 are designated by the same reference numerals, and a description thereof will be omitted.

In this embodiment, a heating means 24a is provided on each shutter 24. According to this embodiment, the temperature of the each cell 6 is maintained approximately constant regardless of whether the corresponding shutter 24 is open or closed, because the shutter 24 is heated by the heating means 24a. For this reason, it is possible to suppress the temperature change of each cell 6.

The temperature change of the cell 6 after opening the shutter 24 was measured to be approximately 1 °C under the conditions where the temperature of the substrate 1 is 700 °C, the temperature of the cell 6 is 150 °C and the heating temperature of the heating means 24a is 500 °C. In this case, the temperature of the cell 6 can return to the 150 °C in approximately one minute.

But when no heating means 24a is provided, the temperature of the cell 6 rises 6 °C in 30 seconds after opening the shutter 24, and it takes approximately 6 minutes to return the temperature of the cell 6 to the 150 °C.

Therefore, this embodiment is effective in forming a superconductor layer having a high quality because the temperature change of the cell 6 can be suppressed.

Generally, the superconductor layer is formed under a relatively high temperature in the range of 500 to 800 °C. For this reason, when the superconductor layer is formed by the plasma CVD and the substrate temperature is decreased under the low pressure, the oxygen in the formed superconductor layer may escape and the oxygen quantity may change before the substrate temperature is lowered to room temperature. In this case, the reproducibility of the superconductor layers becomes poor, and the superconductivity may be lost in some cases. As a method of overcoming this problem, it is conceivable to raise the pressure within the deposition chamber near atmospheric pressure after forming the superconductor layer. However, there is a danger in that the oxidizer may enter within the cells and oxidize the source materials themselves. For this reason, it is undesirable to lower the substrate temperature after the formation of the superconductor layer until the cell temperature returns to the normal temperature, but this inevitably deteriorates the process efficiency.

Next, a description will be given of an embodiment of a method of forming a high temperature superconductor layer using plasma CVD, which prevents the superconductive characteristic from deteriorat-

ing due to oxygen escaping from the superconductor layer when the substrate temperature is lowered after formation of the layer, and enables forming of the superconductor layers with a satisfactory reproducibility.

According to a second embodiment of the method according to the present invention, a high temperature superconductor is formed on a substrate by generating plasma in an atmosphere in which gases of halide source materials and an oxidizer coexist, and the temperature of the substrate having the superconductor layer formed thereon is lowered within the plasma of the oxidizer gas. For example, the oxidizer is oxygen, nitrogen oxide ($NO_x$) and water ($H_2O$), but is oxygen in a desirable embodiment.

According to this embodiment, the oxidizer plasma generates radicals because the substrate temperature is lowered within the oxidizer plasma after formation of the superconductor layer. Thus, the oxidation becomes more active and improved, and the oxygen quantity within the superconductor layer can be maintained by compensating for the oxygen which escapes while the substrate temperature is lowered under the low pressure.

Next, a description will be given of an eleventh embodiment of the apparatus according to the present invention which uses the second embodiment of the method, by referring to FIG.21. In FIG.21, those parts which are the same as those corresponding parts in FIG.16 are designated by the same reference numerals, and a description thereof will be omitted.

In FIG.21, each source boat 7 is heated by the cell heater 8 within the corresponding independent cell 6 and gasified, and is supplied onto the substrate 1 by the carrier gas. The substrate 1 is heated on the susceptor 3 by the substrate heater 5, and is rotated by the rotary mechanism 9 in order to improve the in-plane uniformity of the superconductor layer which is formed. The high frequency electric field is applied between the upper (RF) electrode 2 and the susceptor 3 (lower electrode) so as to generate the oxidizer plasma and accelerate the oxidation. The supply of the source material gases is controlled by a shutter mechanism 22A including the shutters 22. A MgO substrate and a sapphire substrate are used as the substrate 1 in this embodiment.

In this embodiment, oxygen and water are used as the oxidizer. The oxygen is introduced as it is into the deposition region while the water is introduced by bubbling with He gas.

A Bi-Sr-Ca-Cu-O system superconductor layer was formed on the MgO substrate 1 and the sapphire substrate 1 to a thickness of approximately 700 Å by selecting the conditions from the ranges shown in the following Table 1, where "Flow Rate" indicates the flow rate of the carrier gas. The carrier gas used was He.

Table 1

| Source Material | Cell Temperature (°C) | Flow Rate (cc/min) |
|---|---|---|
| $BiCl_3$ | 100 to 300 | 5 to 1000 |
| $SrI_2$ | 750 to 1200 | 5 to 1000 |
| $CaI_2$ | 750 to 1200 | 5 to 1000 |
| CuI | 350 to 600 | 5 to 1000 |

In addition, the flow rate of $O_2$ as the oxidizer was selected in the range of 5 to 2000 cc/min, and the the $H_2O$ is supplied by bubbling the He gas into pure water which is adjusted to a temperature ranging from room temperature to 100°C at a rate of 10 to 1000 cc/min and introducing the humidified He gas into the deposition chamber 4. The substrate temperature was selected in the range of 500 to 900°C. The high frequency power was selected in the range of 20 to 500 W, and the pressure within the deposition region was set in the range of 0.01 to 10 Torr.

After formation of the superconductor layer, the substrate temperature was lowered to room temperature in the following three different conditions.

1) Lower the substrate temperature within a non-plasma atmosphere including no oxidizer.

2) Lower the substrate temperature within a non-plasma atmosphere including oxidizer.

3) Lower the substrate temperature within an oxygen plasma atmosphere at an oxygen pressure of 0.1 Torr.

When the layer was formed under the condition 1) or 2), a reddish brown insulator layer was obtained. But when the layer was formed under the condition 3), a black conductive layer was obtained. FIG.22 shows a resistance versus temperature characteristic of the layer which is obtained by the condition 3). As may be seen from FIG.22, the resistance decreases similarly to a metal layer with decreasing temperature, and the superconductive characteristic is obtained. Hence, the method of lowering the substrate temperature after formation of the layer greatly affects the superconductive characteristic of the formed layer. In this embodiment, the oxygen pressure is set to 0.1 Torr, but similar results were obtained in the oxygen pressure range of 0.01 to 10 Torr. The oxidizer used when lowering the substrate temperature may be selected from $O_2$, $No_x$, $H_2O$ and the like or a combination of such may be used. $O_2$ in particular is desirable as the oxidizer.

The RF plasma is used in this embodiment, but similar effects can of course be obtained using glow plasma and electron cycrotron resonance (ECR) plasma.

According to the eleventh embodiment, the superconductive characteristic of the formed layer is improved by maintaining the substrate within the plasma even after the formation of the layer and preventing the oxygen within the layer from escaping while the substrate temperature is lowered. However, it was found that the reproducibility of the superconductor layers and particularly the control of the oxygen quantity within the layer are still not extremely good. That is, when the substrate is maintained within the plasma after the formation of the layer until the substrate temperature reaches room temperature, the oxygen quantity within the layer may become too large. In addition, the damage to the superconductor layer due to being subjected to the influence of the plasma for a relatively long time becomes no longer negligible, and new problems arose in that the crystal properties and superconductive characteristic of the layer become poor.

Accordingly, a description will now be given of a third embodiment of the method according to the present invention, in which the above new problems are eliminated. According to this embodiment, as a means of controlling the oxygen quantity within the layer while suppressing the damage caused by the plasma to the layer surface to a minimum, the substrate temperature is lowered within the oxidizer plasma to a predetermined temperature after formation of the layer, and the substrate temperature is thereafter lowered by stopping the plasma. As a result, a high temperature superconductor layer having a high quality can be formed with fine reproducibility. In other words, when lowering the substrate temperature after formation of the layer, the substrate is maintained within the oxidizer plasma until the substrate temperature is lowered to the predetermined temperature because the escaping of oxygen is particularly a problem within this temperature range. But after the substrate temperature is lowered to the predetermined temperature, the plasma is stopped so as to minimize the damage to the surface of the layer caused by the plasma. Therefore, it is possible to control the oxygen quantity within the layer even when the substrate temperature is lowered under the low pressure, and the reproducibility of the superconductor layers is improved.

A twelfth embodiment of the apparatus according to the present invention which uses the third embodiment of the method according to the present invention has a construction identical to that shown in FIG.21. Accordingly, an illustration of the twelfth embodiment of the apparatus will be omitted. In this twelfth embodiment, oxygen and water are used as the oxidizer. The oxygen is introduced into the deposition region as it is, while the water is introduced into the deposition region with the bubbling of He. A MgO substrate and a sapphire substrate were used as the substrate 1.

This twelfth embodiment of the apparatus was used to form a Bi system superconductor layer having a thickness of approximately 700 Å under constant deposition conditions. Thereafter, the temperature of the substrate 1 was lowered to room temperature by varying the temperature at which the plasma is stopped, where the oxygen pressure was set constant within the range of 0.1 to 1 Torr. An average temperature lowering speed until the stopping of the plasma was set to 25 ± 10°C/min. The deposition conditions were selected from the ranges shown in the following Table 2, where "Flow Rate" indicates the flow rate of the carrier gas. The carrier gas used was He.

Table 2

| Source Material | Cell Temperature (°C) | Flow Rate (cc/min) |
|---|---|---|
| $BiCl_3$ | 100 to 300 | 5 to 1000 |
| $SrI_2$ | 750 to 1200 | 5 to 1000 |
| $CaI_2$ | 750 to 1200 | 5 to 1000 |
| CuI | 350 to 600 | 5 to 1000 |

In addition, the flow rate of $O_2$ as the oxidizer was selected in the range of 5 to 2000 cc/min, and the $H_2O$ is

supplied by bubbling the He gas into pure water which is adjusted to a temperature ranging from room temperature to 100 °C at a rate of 10 to 1000 cc/min and introducing the humidified He gas into the deposition chamber 4. The substrate temperature was selected in the range of 500 to 900 °C. The high frequency power was selected in the range of 20 to 500 W, and the pressure within the deposition region was set in the range of 0.01 to 10 Torr.

FIG.23 shows the effects of the substrate temperature at which the plasma is stopped (hereinafter simply referred to as a stopping temperature) on the (002) peak intensity of the X-ray diffraction of the (2212)-Bi system superconductor layer (hereinafter simply referred to as a peak intensity) and the superconducting temperature $T_c$. At the stopping temperatures of 290 °C or greater, a reddish brown insulator layer is formed. But at the stopping temperatures of less than 290 °C, a black conductor layer is formed and the superconductivity was confirmed at low temperatures. Both the peak intensity and the superconducting temperature $T_c$ increase with decreasing stopping temperature down to approximately 230 °C, and the crystal properties and electric characteristic are improved. However, both the peak intensity and the superconducting temperature $T_c$ have maximum values when the stopping temperature is within the range of approximately 200 to 250 °C, and the crystal properties and electric characteristic deteriorate when the stopping temperature falls below this range. From these experimental results, it was confirmed that both the crystal properties and electric characteristic of the high temperature superconductor layer improve when the substrate temperature is lowered within the plasma to a predetermined temperature after formation of the layer and thereafter lowered by stopping the plasma.

The RF plasma is used in this embodiment, but similar effects can of course be obtained using glow plasma and ECR plasma.

The superconducting temperature is approximately 70K in FIGS.22 and 23, but the superconducting temperature is approximately 46K in FIG.7 which also shows an embodiment of the present invention. This difference is due to the different conditions under which the superconductor layers are formed in FIGS.22 and 23 and in FIG.7.

The cell 6 is made of an insulator material such as crystal and ceramics, and the cell 6 has the shape of a pipe with a rounded tip end. A small hole is provided at the tip end of an inner tube 6a for introducing the generated material gas into the deposition chamber 4. He gas flows in the periphery of this hole so that the oxide gas within the deposition chamber 4 will not directly contact the hole part of the inner tube 6a. However, the material gas is oxidized by the scattering oxide gas, and an oxide material gradually adheres on the periphery of the hole of the inner tube 6a after the cell 6 is used for a long time and the hole is eventually blocked.

In addition, according to the method of generating the material gas described above, the quantity of the material gas supplied to the deposition region is controlled by the flow rate of the He gas which flows over the solid or liquid material. For this reason, the quantity of the material gas supplied to the deposition region changes depending on the pressure within the inner tube 6a. In other words, even when the flow rate of the He gas introduced from the carrier gas introducing pipe 10 is constant (for example, atmospheric pressure at 0 °C), the flow rate within the inner tube 6a changes depending on the temperature within the inner tube 6a and the size of the hole of the inner tube 6a. Particularly, since the size of the hole of the inner tube 6a changes with time for the above described reasons, it is impossible to control the quantity of the material gas supplied to the deposition region and the superconductor layer cannot be formed with a stable reproducibility.

Accordingly, a description will now be given of an embodiment in which a pressure adjusting needle is provided in the cell to adjust the size of the hole of the inner tube, FIG.24A shows a cell structure which is employed in a thirteenth embodiment of the apparatus according to the present invention, and FIG.24B shows a part of the cell structure shown in FIG.24A on an enlarged scale. In FIGS.24A and 24B, those parts which are the same as those corresponding parts in FIGS.10A and 10B are designated by the same reference numerals, and a description thereof will be omitted.

As shown in FIGS.24A and 24B, it is possible to adjust the size of a hole 30 of the inner tube 6a depending on the position of a pressure adjusting needle 32 along a direction X, so that the pressure inside the inner tube 6a becomes constant. By controlling the position of the pressure adjusting needle 32 while detecting the pressure within the inner tube 6a, it becomes possible to accurately control the quantity of a material gas 31 which is supplied to the deposition region. In addition, it is possible to remove the oxide material adhered on the periphery of the hole 30 by moving the pressure adjusting needle 32 in the direction X.

FIG.25 shows a control part for controlling the pressure adjusting needle 32. A pressure gage (sensor) 35 detects the pressure inside the inner tube 6a, and an output detection signal of the pressure gage is supplied to a pressure controller 36. The pressure controller 36 compares the pressure detected by the pressure gage 35 and a preset pressure, and supplies a control signal to a needle driving device 37 so as to minimize the difference between the detected pressure and the preset pressure. The needle driving device 37 drives the pressure adjusting needle 32 in the direction X depending on the output control signal of the pressure controller 36. By repeating such a control operation, it is possible to maintain the pressure within the inner tube 6a to the preset pressure. For example, when the size of the hole 30 decreases due to the oxide material adhered on the periphery of the hole 30, the pressure adjusting needle 32 is moved in a direction to increase the size of the hole 30 so that the size of the hole 30 is maintained constant, and it is thus possible to control the pressure within the inner tube 6a constant. According to this embodiment, the quantity of the material gas 31 which is supplied to the deposition region can be controlled accurately at any time.

For example, a platinum wire forming the heater 8 is wound around the outer periphery of the inner tube 6a. The heater 8 heats the entire inner tube 6a, and the source boat 7 which contains the source material and is placed within the inner tube 6a is heated to generate the material gas. FIG.26A is a plan view showing the inner tube 6a and the heater 8, and FIG.26B shows a partial cross section of the structure shown in FIG.26A. But according to the structure shown in FIGS.26A and 26B, the following problems may occur. First, as shown in FIG.26B, the contact between the heater 8 and the inner tube 6a depends on how the heater 8 is wound, and a temperature distribution occurs within the inner tube 6a. Second, when the temperature of the source material is high (for example, 1000$^{\circ}$C or greater), the temperature distribution may cause a crack in the inner tube 6a. Third, particularly when the temperature of the source material needs to be high, the temperature of the heater 8 becomes greater than or equal to the high temperature of the source material, and even platinum having the relatively high melting point may evaporate in vacuum and cause deterioration or break in the heater wire.

In other words, since the heater 8 has a circular cross section, the contact between the heater 8 and the inner tube 6a is poor regardless of how the heater 8 is wound around the outer periphery of the inner tube 6a. In addition, the heater 8 and the inner tube 6a does not make contact at parts depending on how the heater 8 is wound around the outer periphery of the inner tube 6a. The poor contact described above is introduced because the heater 8 is wound around the outer periphery of the inner tube 6a and inevitable.

Accordingly, a description will now be given of an embodiment which eliminates the poor contact described above. In a fourteenth embodiment of the apparatus according to the present invention, the heater material is formed on the inner tube of the cell by evaporation, sputtering, CVD, or the like. Hence, no gap is formed between the inner tube and the heater, thereby eliminating a temperature difference between the inner tube of the cell and the heater.

FIG.27A shows a plan view of an essential part of a cell structure used in the fourteenth embodiment of the apparatus according to the present invention, and FIG.27B shows a partial cross section of the structure shown in FIG.27A. In FIGS.27A and 27B, those parts which are the same as those corresponding parts in FIGS.10A and 10B are designated by the same reference numerals, and a description thereof will be omitted.

In this embodiment, a heater 40 has a rectangular cross section. Hence, the heater 40 and the inner tube 6a of the cell 6 are in contiguous contact, and the heat generated by the heater 40 can be transferred to the inner tube 6a with a high efficiency. As a result, the temperature of the heater 40 and the temperature of the inner tube 6a become approximately the same, and the temperature distribution within the inner tube 6a becomes gradual because the abnormal heating of the heater 40 can be prevented. Consequently, it is possible to prevent breaking of the heater 40 and cracking of the inner tube 6a.

However, when the heater 40 having the rectangular cross section is simply wound around the outer periphery of the inner tube 6a, the problems described in conjunction with FIGS.26A and 26B may still occur. Hence, a description will now be given of a method of forming the heater 40, by referring to FIGS.28A through 28D which show cross sections of a part of the inner tube 6a.

As shown in FIG.28A, a heater material 41 having a high melting point is formed on the surface of the inner tube 6a which is made of an insulator material such as crystal and ceramics by evaporation. The heater material 41 is formed to a thickness with which the desired electrical resistance is obtained. For example, platinum is used as the heater material 41. The contact between the heater material 41 and the inner tube 6a is improved by heating the inner tube 6a to approximately the temperature at which the inner tube 6a is used, thereby preventing the formed heater 40 from coming off the inner tube 6a.

Next, as shown in FIG.28B, a mask 42 having the desired heater shape is formed on the surface of the heater material 41. In addition, as shown in FIG.28C, the heater material 41 is etched by a wet etching or a dry etching using the mask 42. Thereafter, the mask 42 is removed, and the heater 40 which makes contiguous contact with the inner tube 6a is formed as shown in fIG.28D.

It is of course possible to form the heater material 41 by a method other than evaporation, such as CVD, electron beam (EB) evaporation and plating. In addition, materials having a high melting point other than platinum may be used as the heater material 41. The heater material 41 need not necessarily be etched to form the heater 40, and unwanted parts of the heater material 41 may be removed by a mechanical process, a laser process or the like.

When patterning the superconductor layer, it is usual practice to form a resist layer on the superconductor layer, form a mask pattern using a photolithography technique and thereafter carry out an etching. A wet etching using an acid such as phosphoric acid and hydrochloric acid, or a dry etching using a gas plasma may be used for the etching.

However, when the wet etching is used, the moisture, etching solution and the like inevitably infiltrate from the side portions of the pattern and introduces undesirable effects on the superconductive characteristic of the layer. On the other hand, when the dry etching is used, no gas capable of effectively etching the high temperature superconductor layer has yet been found. In addition, there are not many appropriate resist materials suited for use with the gas which can etch the high temperature superconductor layer to a certain extent. Furthermore, it is uncertain what undesirable effects are introduced to the superconductor layer when the resist material is coated thereon.

Accordingly, a description will now be given of a fourth embodiment of the method according to the present invention in which the superconductor layer can be patterned by selective deposition. In this embodiment, a pattern made of a metal which easily reacts with the high temperature superconductor material is formed on the substrate before forming the superconductor layer. When the halide system CVD is carried out thereafter to form the high temperature superconductor layer on the substrate, the high temperature superconductor layer is selectively formed on the substrate at parts other than the parts having the metal pattern. The halide system CVD has an extremely strong substrate selecting characteristic. In other words, the high temperature superconductor layer is formed on the substrate which is made of MgO, $SrTiO_3$, sapphire or the like which uneasily reacts to the source material gases and the oxide materials. But on the other hand, when the halogen gas is supplied on a metal such as Au, the gas and the metal react and the deposition of the high temperature superconductor layer is interfered. Hence, the above described characteristic is utilized in this embodiment by forming a metal pattern made of Au or the like on the substrate which is stable with respect to the source material gases, and the halide system CVD is carried out thereafter to selectively form the high temperature superconductor layer on parts of the substrate where the metal pattern is not formed.

First, as shown in FIG.29A, a metal layer pattern 1-2 which easily reacts with the source material gases is formed on a substrate 1-1 by using a photolithography technique. Then, as shown in FIG.29B, a high temperature superconductor layer is formed on the substrate 1-1 by a halide system CVD. The high temperature superconductor crystallizes only at the parts where the substrate 1-1 is exposed, and a high temperature superconductor pattern 1-3 shown in FIG.29C is formed as a result. For example, the substrate 1-1 is made of sapphire, MgO, $SrTiO_3$ or the like, and the metal layer pattern 1-2 is made of Au. The high temperature superconductor need not be a Bi system material, and similar effects are obtainable using any of La, Y and Tl system materials.

The apparatus used to form the superconductor layer in this embodiment is identical to that shown in FIG.21 under the following conditions. Oxygen and water were used as the oxidizer. The oxygen was introduced into the deposition region as it is, while the water was bubbled with He gas and introduced into the deposition region. Mgo, sapphire and $SrTiO_3$ substrates were used as the substrate 1-1. After forming a Bi system superconductor layer having a thickness of approximately 700 Å by selecting the conditions from the ranges shown in the following Table 3, where "Flow Rate" indicates the flow rate of the carrier gas, the substrate temperature was lowered to room temperature. The oxygen pressure was set constant within the range of 0.1 to 1 Torr.

Table 3

| Source Material | Cell Temperature (°C) | Flow Rate (cc/min) |
|---|---|---|
| $BiCl_3$ | 100 to 300 | 5 to 1000 |
| $SrI_2$ | 750 to 1200 | 5 to 1000 |
| $CaI_2$ | 750 to 1200 | 5 to 1000 |
| CuI | 350 to 600 | 5 to 1000 |

In addition, the flow rate of $O_2$ as the oxidizer was selected in the range of 5 to 2000 cc/min, and the $H_2O$ is supplied by bubbling the He gas into pure water which is adjusted to a temperature ranging from room temperature to 100° C at a rate of 10 to 1000 cc/min and introducing the humidified He gas into the deposition chamber 4. The substrate temperature was selected in the range of 500 to 900° C. The high frequency power was selected in the range of 20 to 500 W, and the pressure within the deposition region was set in the range of 0.01 to 10 Torr.

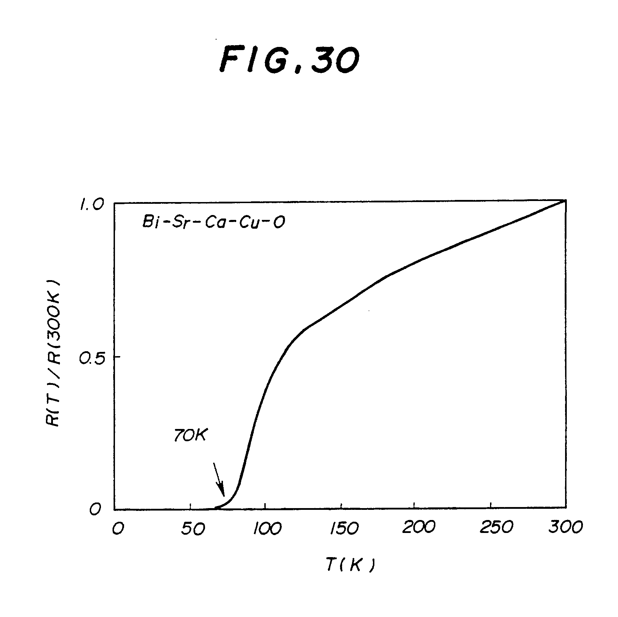

In each of the cases where the MgO, sapphire and $SrTiO_3$ substrates were used as the substrate 1-1, the pattern 1-3 of the superconductor layer was formed only on the exposed parts of the substrate 1-1, and the selective deposition was confirmed. In addition, the layer formed on the metal pattern 1-2 reacted with the gasses and material oxides and became an insulator 1-2' as shown in FIG.29C. FIG.30 shows the resistance versus temperature characteristic of the superconductor layer which is selectively formed on the sapphire substrate after forming of the Au pattern. As shown in FIG. 30, the superconduction occurs at approximately 70K.

Further, the present invention is not limited to these embodiments, but various variations and modifications may be made without departing from the scope of the present invention.

## Claims

1. A method of forming a superconductor layer including the step of setting a substrate (1) within a deposition chamber (4), characterized in that there is provided the step of forming an oxide superconductor layer on a surface of the substrate (1) within the deposition chamber (4) by halides of elements forming the oxide superconductor and plasma of oxidizer.

2. The method as claimed in claim 1, characterized in that said step of forming the oxide semiconductor layer includes generating the oxidizer plasma by applying a high frequency electric field on an atmosphere in which the halides and the oxidizer are supplied onto the substrate (1), thereby generating plasma of the halides.

3. The method as claimed in claim 1, characterized in that said step of forming the oxide semiconductor layer includes generating the oxidizer plasma by applying a high frequency electric field on an atmosphere in which the oxidizer is supplied onto the substrate (1), and supplying the halides onto the substrate within an atmosphere including the oxidizer plasma, thereby generating plasma of the halides.

4. The method as claimed in any of claims 1 to 3, characterized in that said step of forming the oxide semiconductor layer generates the oxidizer plasma in a state where a pressure within the deposition chamber (4) is in a range of $10^{-3}$ to $10^2$ Torr.

5. The method as claimed in any of claims 1 to 3, characterized in that said step of forming the oxide semiconductor layer generates the oxidizer plasma in a state where a pressure within the deposition chamber (4) is in a range of $10^{-2}$ to 10 Torr.

6. The method as claimed in any of claims 1 to 5, characterized in that the oxide superconductor layer is an oxide of bismuth, strontium, calcium and copper.

7. The method as claimed in any of claims 1 to 6, characterized in that the halides include a first halide selected from a first group consisting of bismuth chloride, bismuth bromide and bismuth iodide, a second halide selected from a second group consisting of strontium iodide, strontium chloride and strontium bromide, a third halide selected from a third group consisting of calcium iodide, calcium chloride and calcium bromide, and a fourth halide selected from a fourth group consisting of copper iodide, copper chloride and copper bromide.

8. The method as claimed in any of claims 1 to 7, characterized in that at least the surface of the substrate (1) is made of a material selected from MgO, $Al_2O_3$ and $SrTiO_3$.

9. The method as claimed in any of claims 1 to 7, characterized in that at least the surface of the substrate (1) is made of alumina, the oxide superconductor layer is made of a bismuth system material, and said step of forming the oxide superconductor layer forms the oxide superconductor layer at a substrate temperature of 700° C or less.

10. The method as claimed in any of claims 1 to 7, characterized in that at least the surface of the substrate (1) is made of sapphire ($\alpha$-$Al_2O_3$).

11. The method as claimed in any of claims 1 to 10, characterized in that there is further provided the step of lowering a temperature within the deposition chamber (4) in the oxidizer plasma after formation of the oxide superconductor layer.

12. The method as claimed in claim 11, characterized in that said step of lowering the temperature stops generation of the oxidizer plasma when the temperature within the deposition chamber (4) reaches a predetermined temperature and thereafter continues lowering the temperature.

13. The method as claimed in claim 12, characterized in that said predetermined temperature is in a range of 150 to 300 °C.

14. The method as claimed in claim 12, characterized in that said predetermined temperature is in a range of 230 ± 30 °C.

15. The method as claimed in any of claims 1 to 14, characterized in that there is further provided the step of forming a metal pattern (1-2) on the surface of the substrate (1, 1-1) prior to setting the substrate within the deposition chamber (4).

16. The method as claimed in claim 15, characterized in that said step of forming the metal pattern (1-2) forms the metal pattern from Au.

17. An apparatus for forming an oxide superconductor layer on a surface of a substrate (1), characterized in that there are provided: a deposition chamber (4); a susceptor (3) for supporting the substrate within said deposition chamber; oxidizer supplying means (100) for supplying an oxidizer onto the substrate; plasma generating electrodes (2, 3) for applying a high frequency electric field on the oxidizer on the substrate so as to generate plasma of the oxidizer; a first heater (5) for heating the substrate; and a plurality of cells (6) for supplying halides of elements forming the oxide superconductor layer onto the substrate as source material gases; and that said oxide superconductor layer is formed on the surface of the substrate (1) within the deposition chamber by the halides of the elements forming the oxide superconductor and the oxidizer plasma.

18. The apparatus as claimed in claim 17, characterized in that said oxidizer supplying means (100) supplies the oxidizer in a direction approximately perpendicular to the surface of the substrate (6), and said cells (6) supply the source material gases in directions approximately parallel to the surface of the substrate.

19. The apparatus as claimed in claim 17 or 18, characterized in that there is further provided a rotary mechanism (9) for rotating said susceptor (3) about a rotary axis.

20. The apparatus as claimed in claim 19, characterized in that said cells (6) are arranged radially to the rotary axis.

21. The apparatus as claimed in any of claims 17 to 20, characterized in that said oxide supplying means (100) supplies the oxidizer from one of said plasma generating electrodes (2, 3).

22. The apparatus as claimed in any of claims 17 to 21, characterized in that each of said cells (6) include an inner tube (6a, 6b), a source boat (7) accommodated within the inner tube and on which a source material is placed, and an outlet (A, 30) through which the source material gas is supplied, said outlet having a diameter smaller than that of the inner tube.

23. The apparatus as claimed in claim 22, characterized in that each of said cells (6) further include a second heater (8) provided on the inner tube (6a, 6b) for heating the inner tube, said second heater extending to a vicinity of the outlet (A) of the inner tube.

24. The apparatus as claimed in any of claims 17 to 21, characterized in that each of said cells (6) include a first inner tube (6a) for accommodating a source boat (7) on which a source material is placed, a second inner tube (6b) for accommodating the first inner tube, a space being formed between the first and second inner tubes, and a second heater (8) provided on the first inner tube for heating the first and second inner tubes, said first inner tube being supplied with a carrier gas and said space being supplied with an inert gas so that the first inner tube supplies the source material gas and the second inner tube supplies the inert gas which covers the source material gas.

**25.** The apparatus as claimed in any of claims 17 to 24, characterized in that there is further provided a shutter (12, 22, 23, 24) which confronts an outlet (A) of each of said cells (6), said shutter opening and closing to control the supply of the source material gas.

**26.** The apparatus as claimed in claim 25, characterized in that said shutter (12) includes a cooling mechanism (13) for cooling said shutter.

**27.** The apparatus as claimed in claim 25, characterized in that said shutter (12) includes a suction mechanism (15) for sucking the source material gas which is supplied from each of said cells (6).

**28.** The apparatus as claimed in claim 25, characterized in that there are further provided a cover (21) which isolates said cells (6) and a deposition region in which the substrate (1) is maintained to a predetermined temperature, and windows (21a) formed in said cover for supplying the source material gases into the deposition region, said shutter (22, 23, 24) being arranged at a position corresponding to each of said windows.

**29.** The apparatus as claimed in claim 25 or 28, characterized in that said shutter (24) includes heating means (24a) for compensating for radiation heat from a deposition region in which the substrate (1) is maintained to a predetermined temperature when said shutter is closed.

**30.** The apparatus as claimed in claim 22, characterized in that each of said cells (6) include a needle (32) for adjusting a size of said outlet (30).

**31.** The apparatus as claimed in claim 22, characterized in that each of said cells (6) further include a second heater (40) for heating the inner tube (6a), said second heater having a rectangular cross section and being integrally formed on an outer peripheral surface of the inner tube.

**32.** The apparatus as claimed in any of claims 17 to 31, characterized in that the oxide superconductor layer is an oxide of bismuth, strontium, calcium and copper.

FIG. 1 PRIOR ART

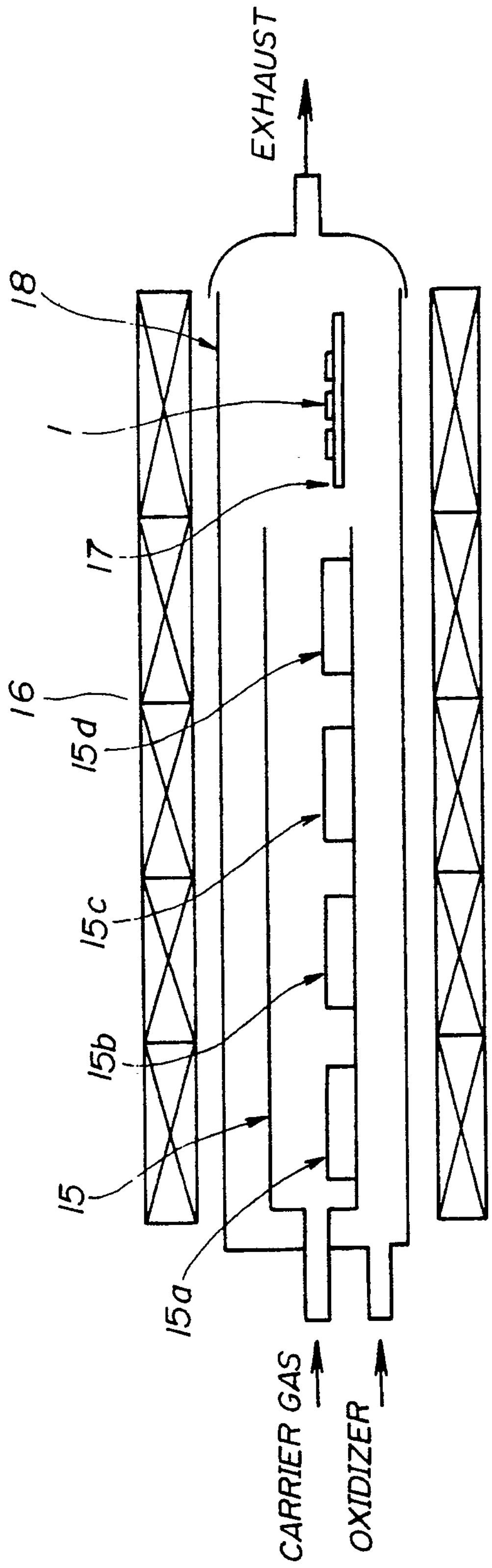

FIG. 2 PRIOR ART

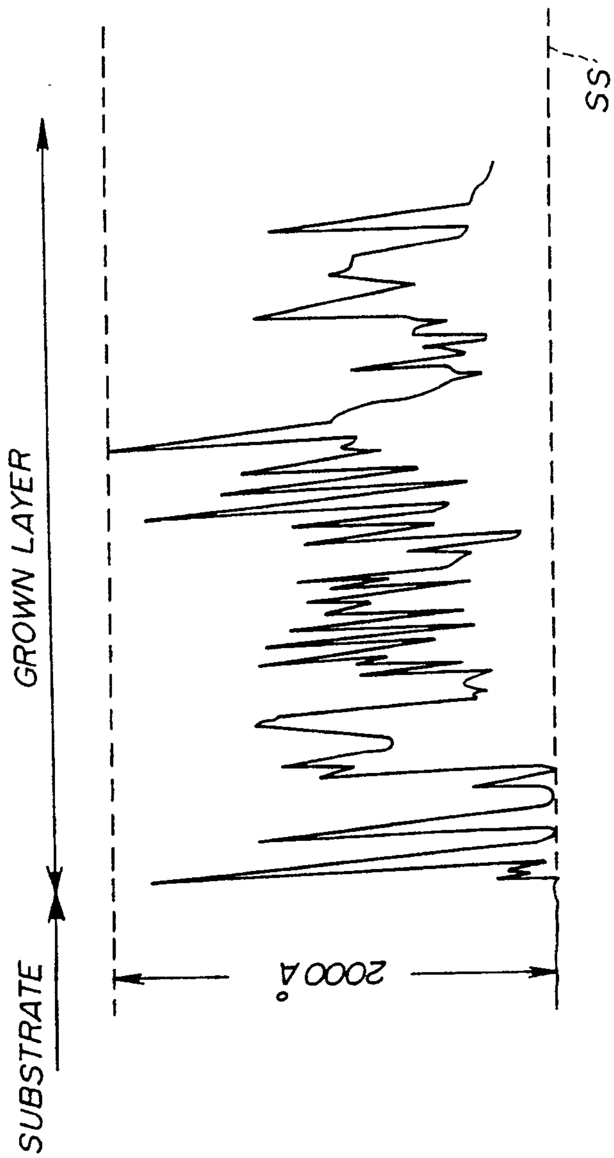

FIG.3

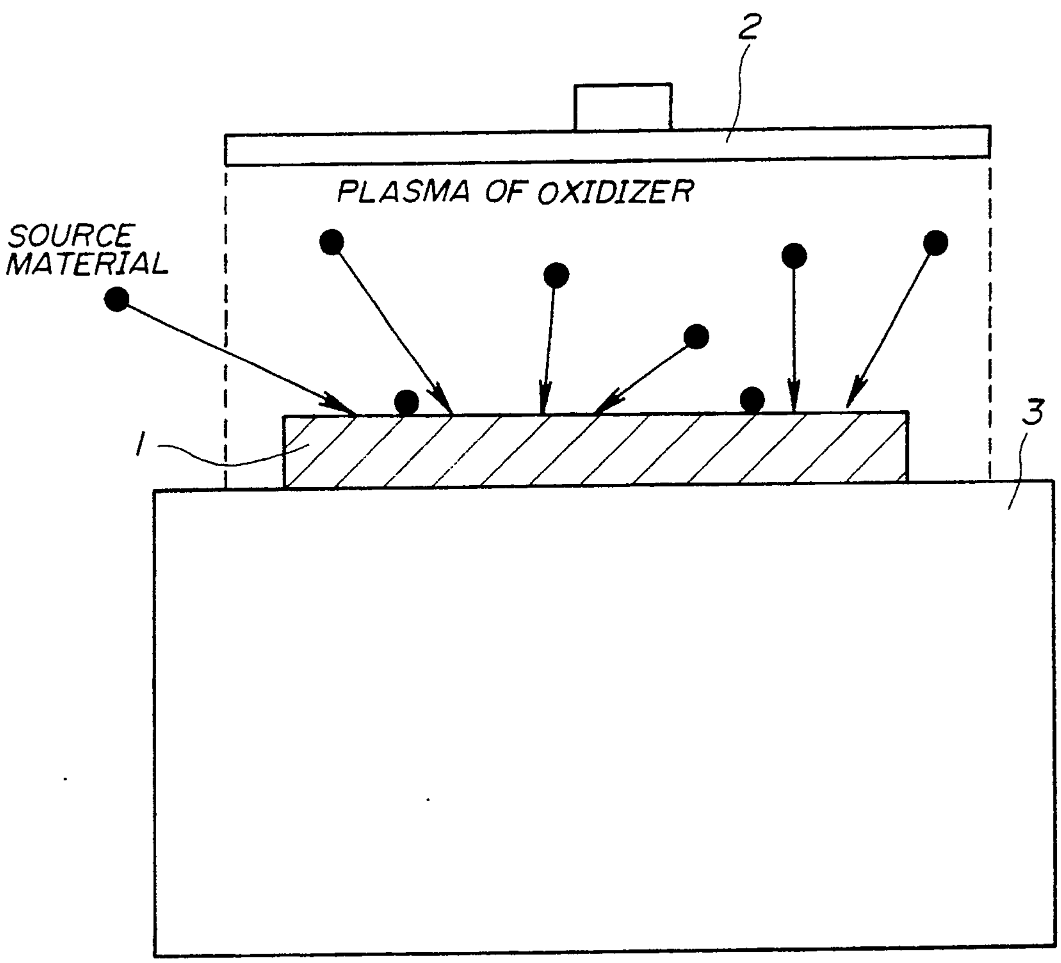

FIG.4A

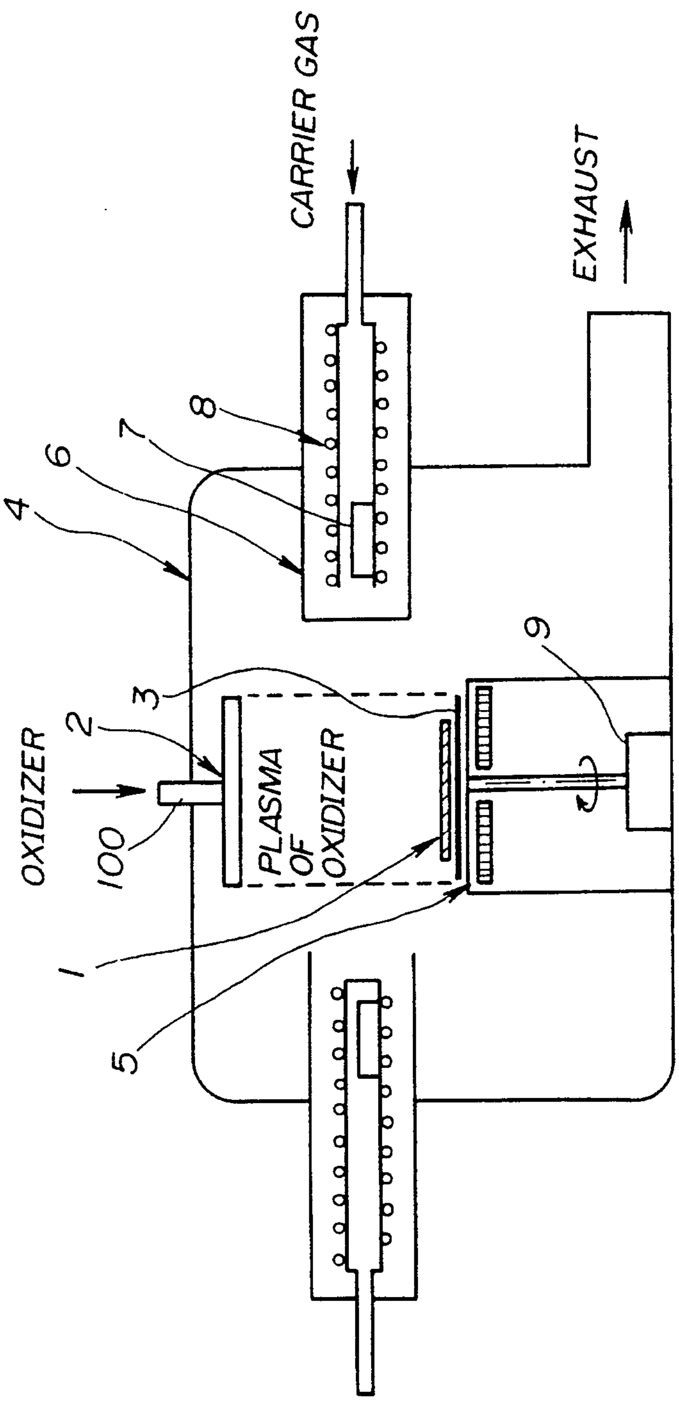
CARRIER GAS
EXHAUST
OXIDIZER
100
PLASMA
OF
OXIDIZER
1
2
3
4
5
6
7
8
9

FIG. 4B

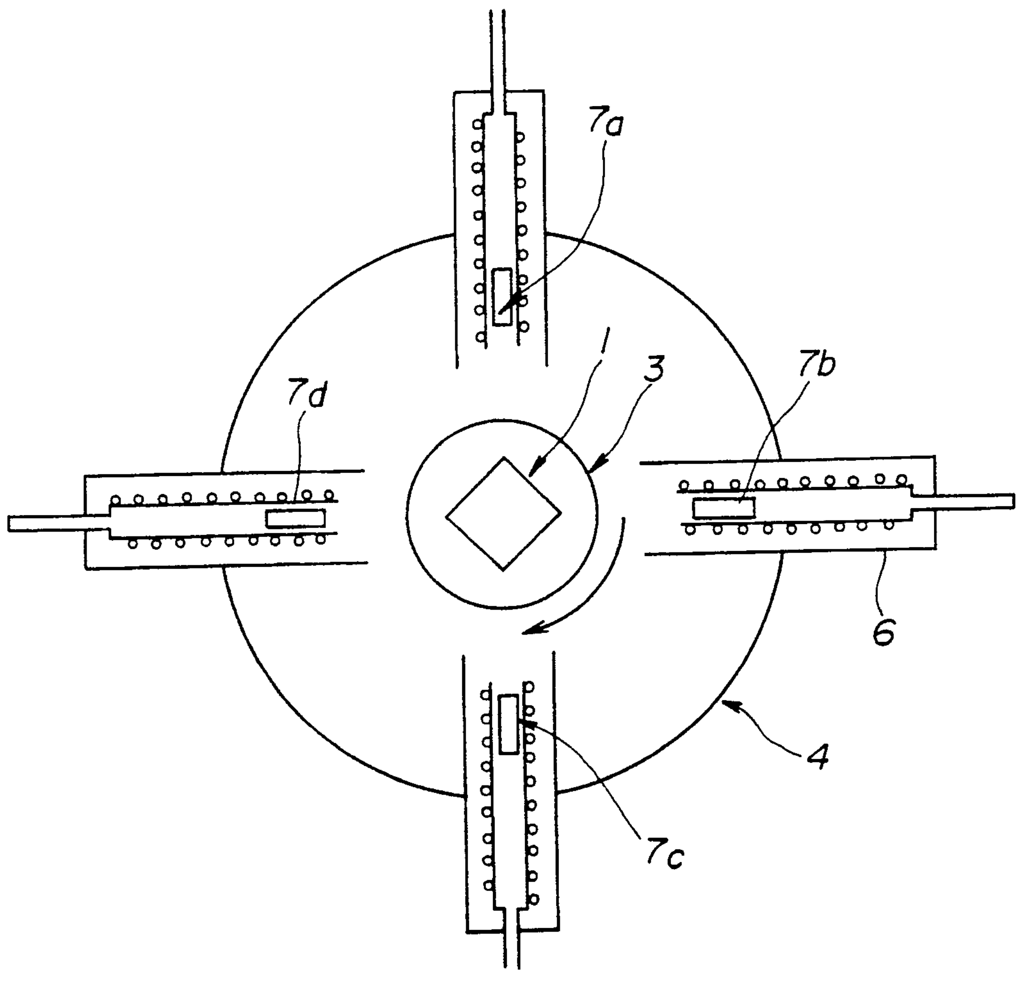

FIG.5

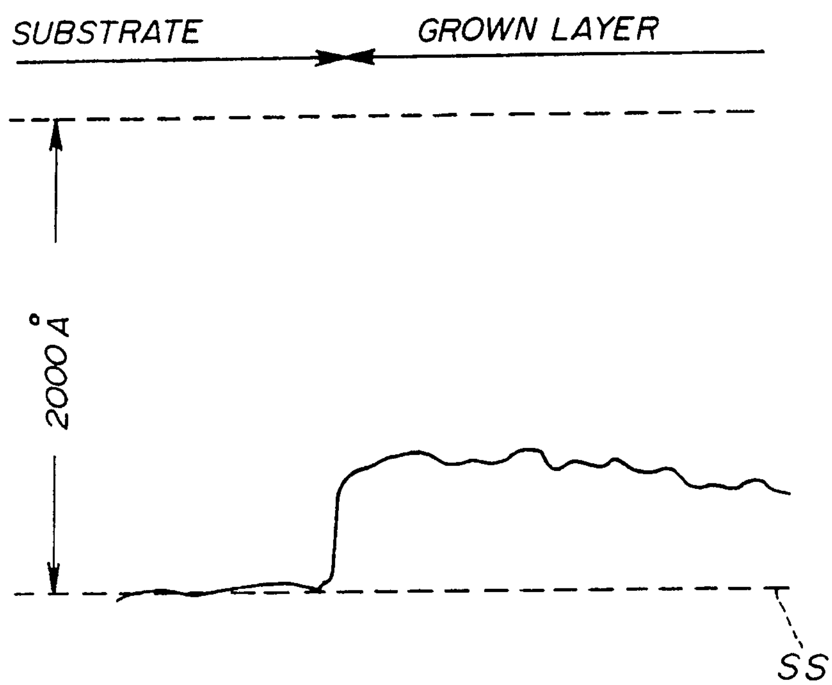

FIG.6

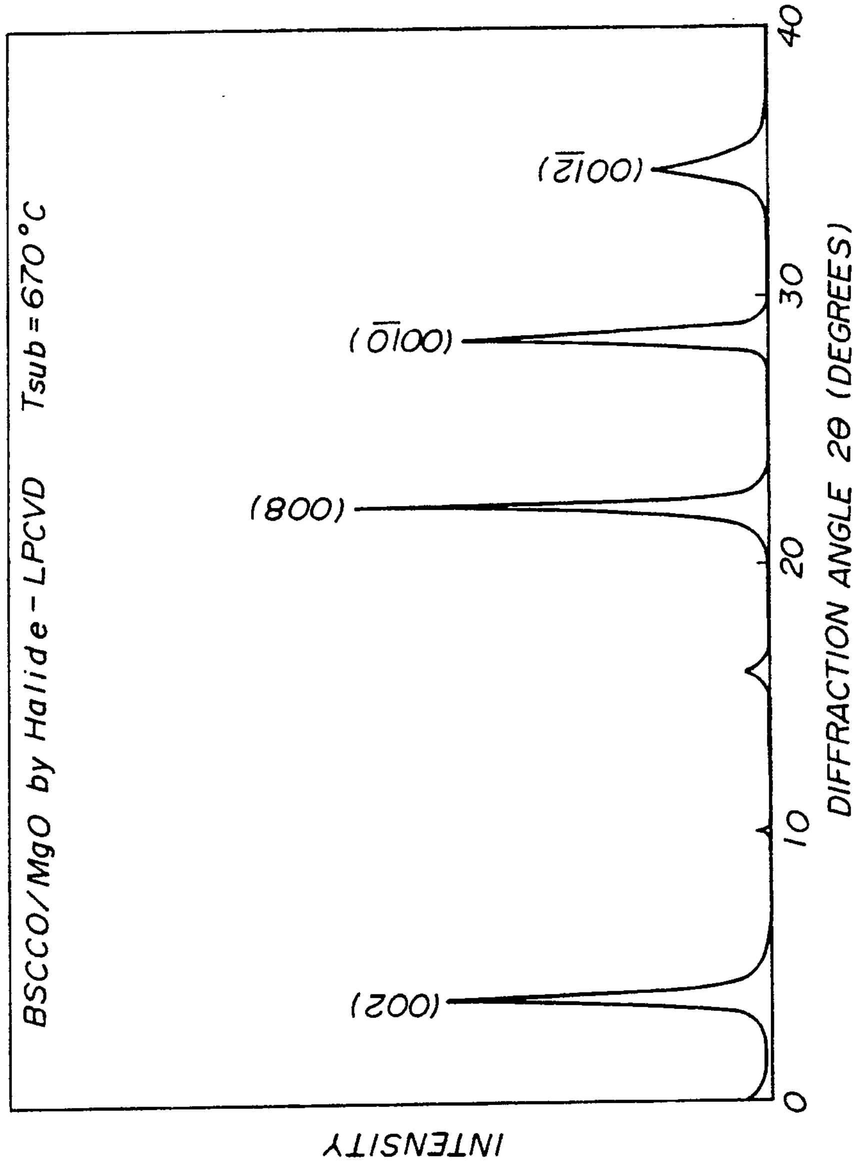
BSCCO/MgO by Halide-LPCVD
Tsub=670°C
(002)
(008)
(0010)
(0012)
0
10
20
30
40
DIFFRACTION ANGLE 2θ (DEGREES)
INTENSITY

FIG. 7

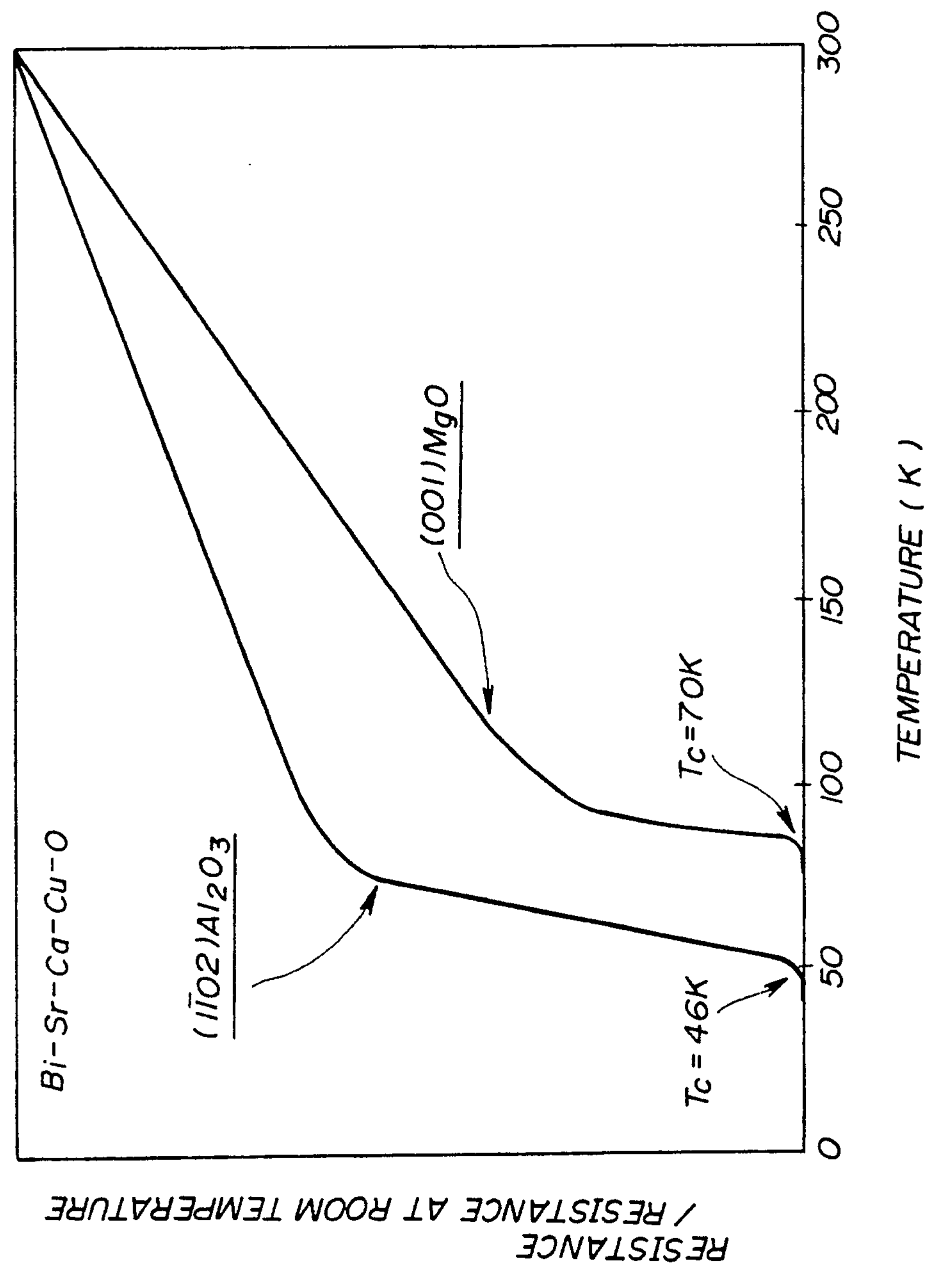
Bi-Sr-Ca-Cu-O
(001) MgO
(1̄102) $Al_2O_3$
Tc=70K
Tc = 46K
0
50
100
150
200
250
300
TEMPERATURE ( K )
RESISTANCE / RESISTANCE AT ROOM TEMPERATURE

FIG.8

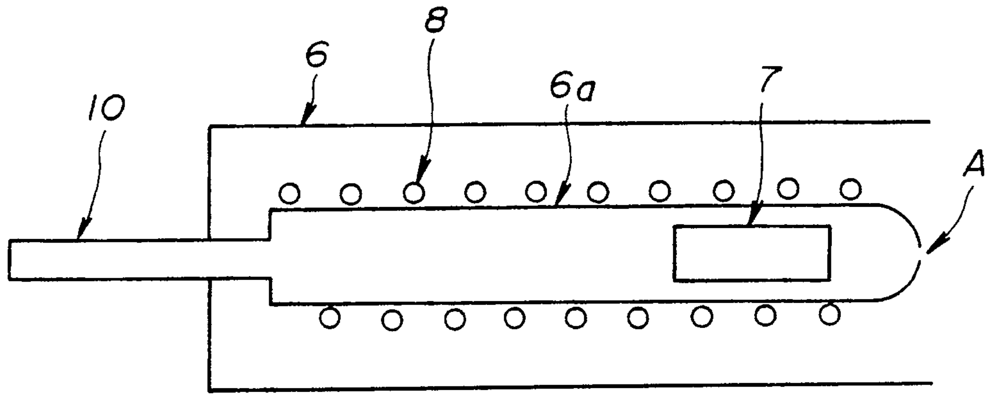


FIG.9

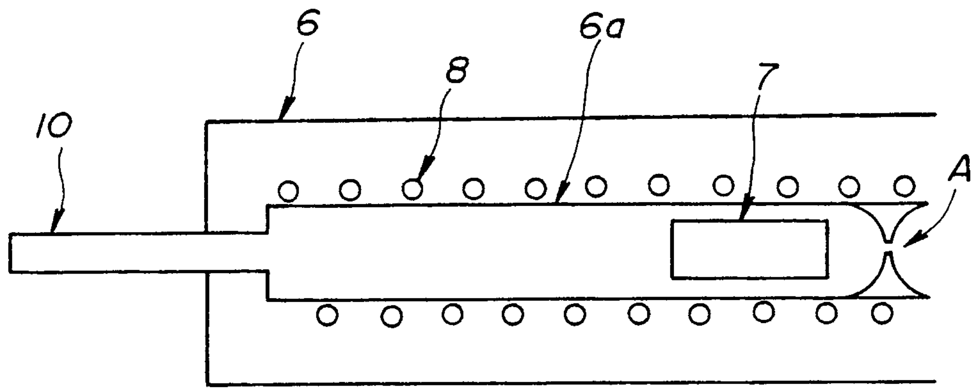

FIG. 10A

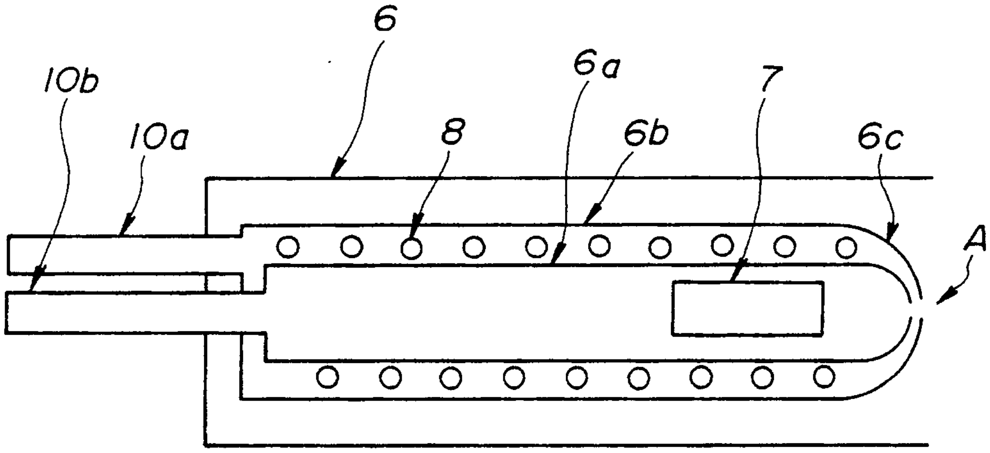


FIG. 10B

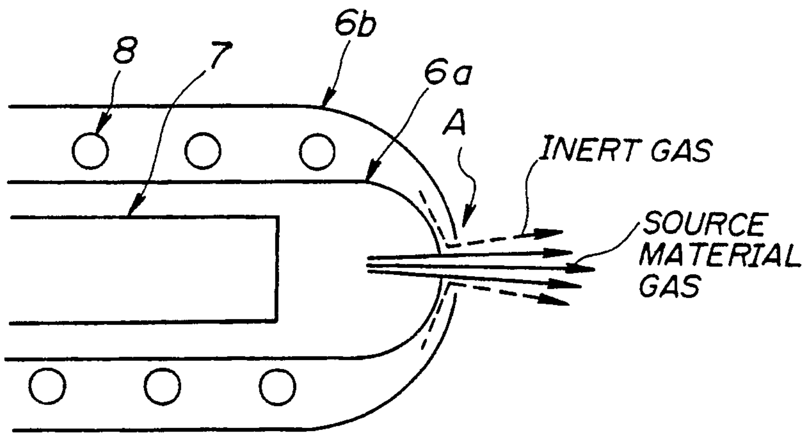

FIG. 11

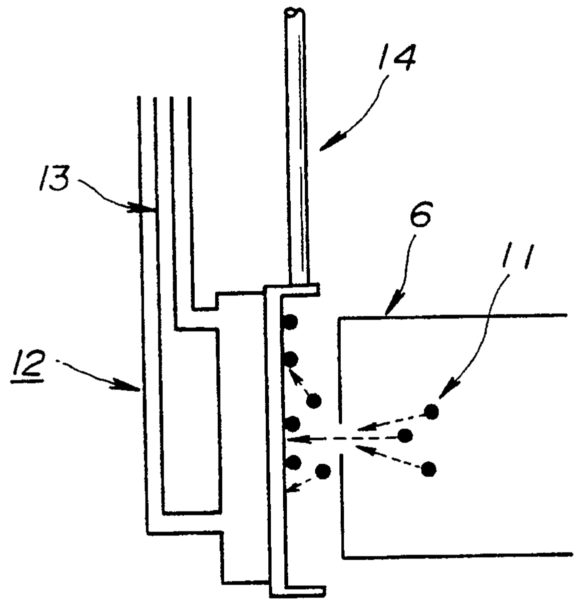


FIG. 12

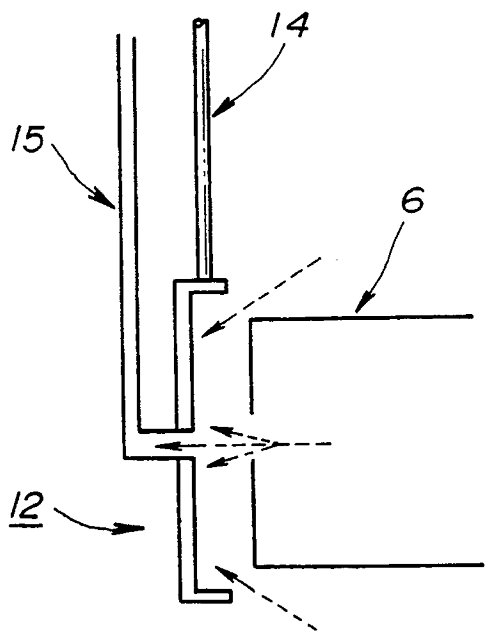

FIG. 13

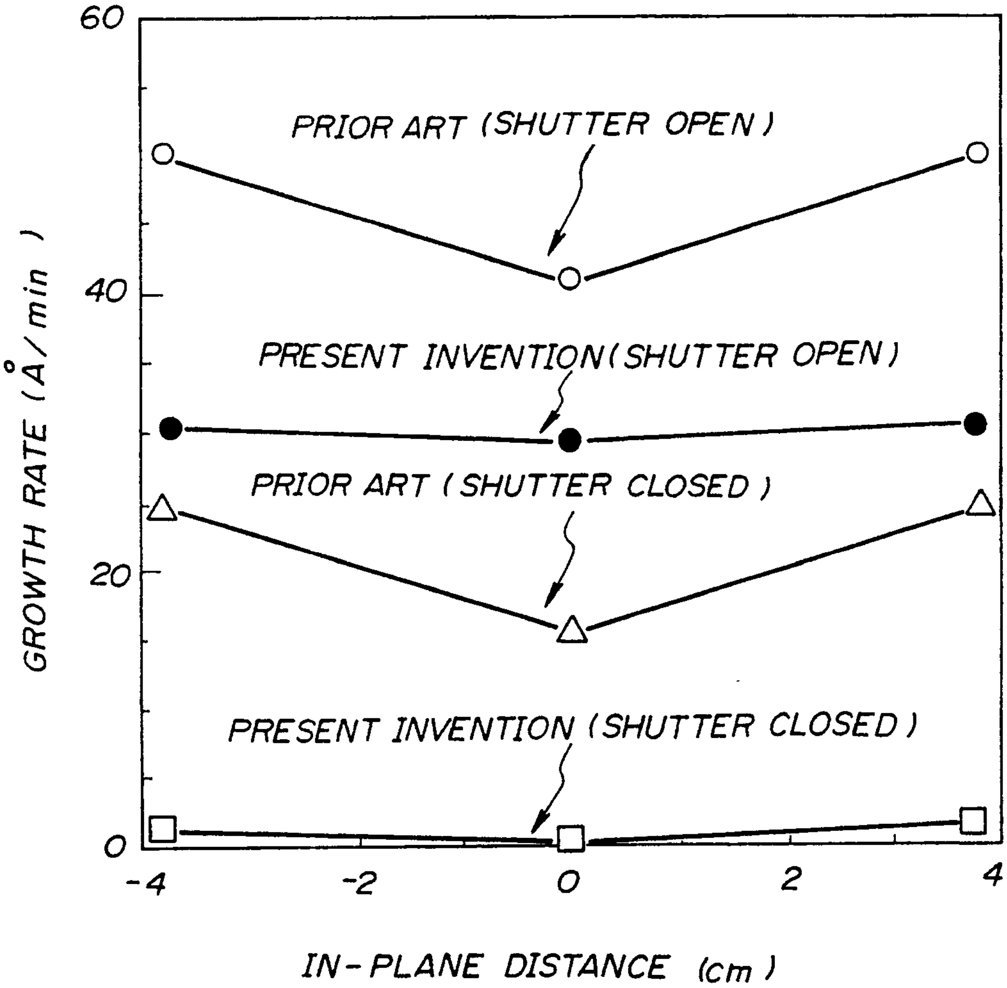
60
40
20
0
-4
-2
0
2
4
GROWTH RATE (Å/min)
IN-PLANE DISTANCE (cm)
PRIOR ART (SHUTTER OPEN)
PRESENT INVENTION (SHUTTER OPEN)
PRIOR ART (SHUTTER CLOSED)
PRESENT INVENTION (SHUTTER CLOSED)

FIG. 14

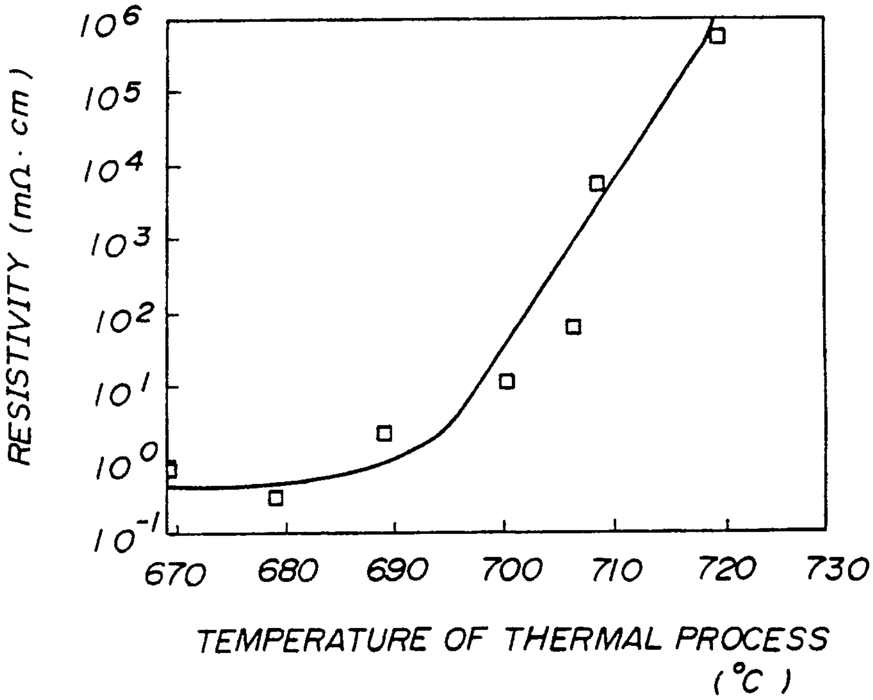
RESISTIVITY (mΩ · cm)
10^6
10^5
10^4
10^3
10^2
10^1
10^0
10^-1
670
680
690
700
710
720
730
TEMPERATURE OF THERMAL PROCESS
(°C)

FIG. 15

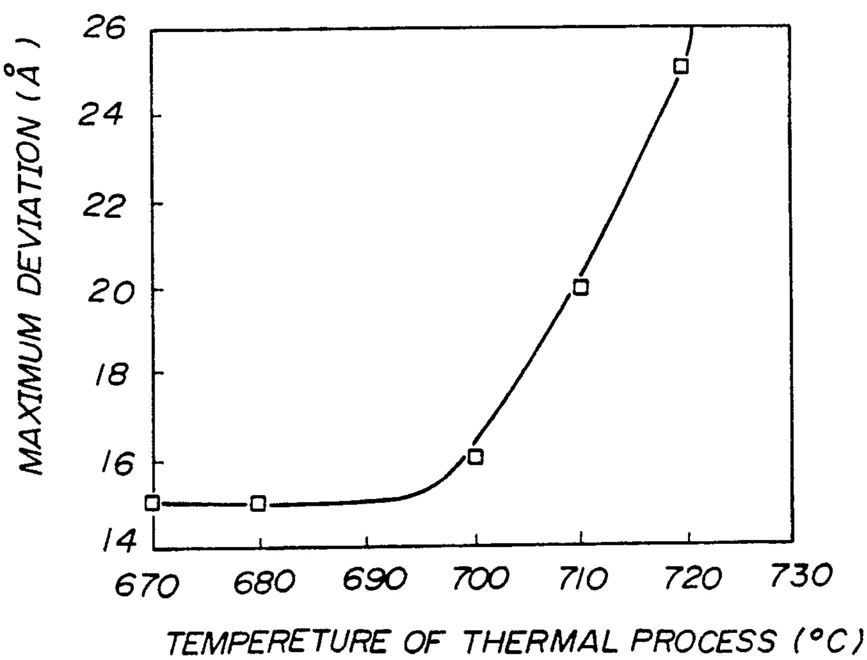
MAXIMUM DEVIATION (Å)
26
24
22
20
18
16
14
670
680
690
700
710
720
730
TEMPERETURE OF THERMAL PROCESS (°C)

FIG.16

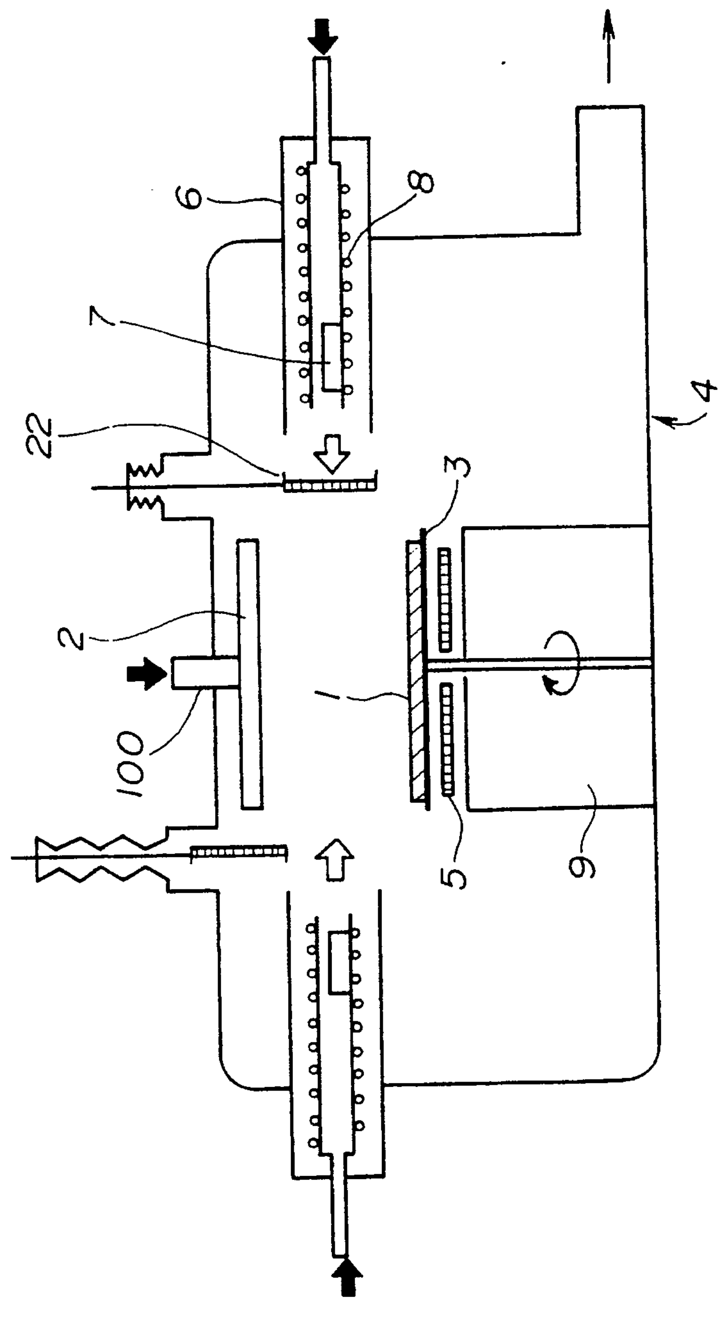

FIG. 17

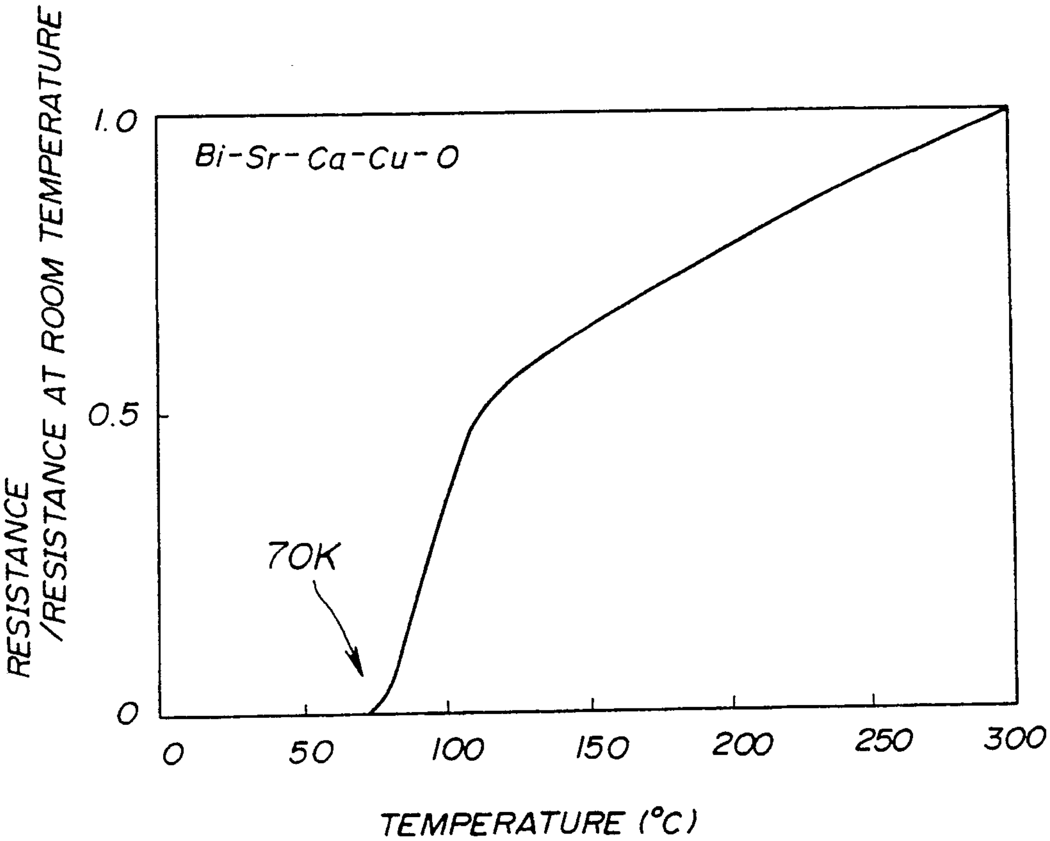
RESISTANCE
/RESISTANCE AT ROOM TEMPERATURE
1.0
0.5
0
Bi-Sr-Ca-Cu-O
70K
0
50
100
150
200
250
300
TEMPERATURE (°C)

FIG.18A

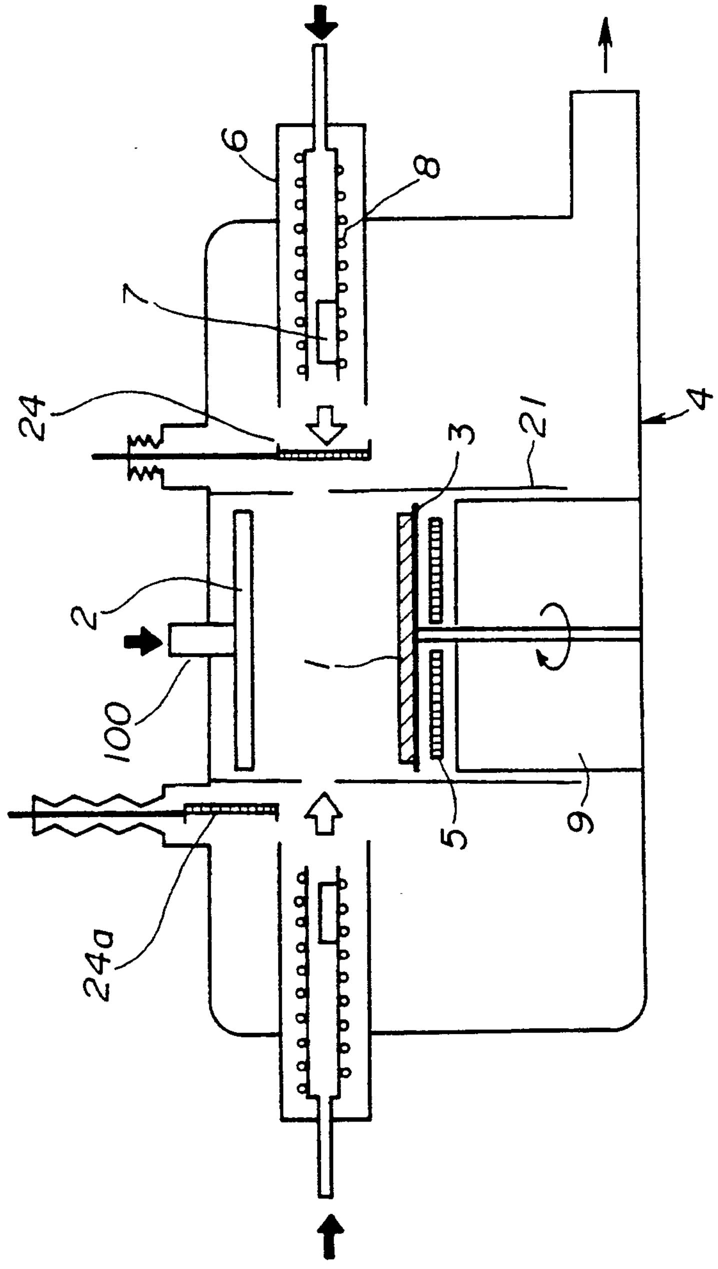

FIG. 18B

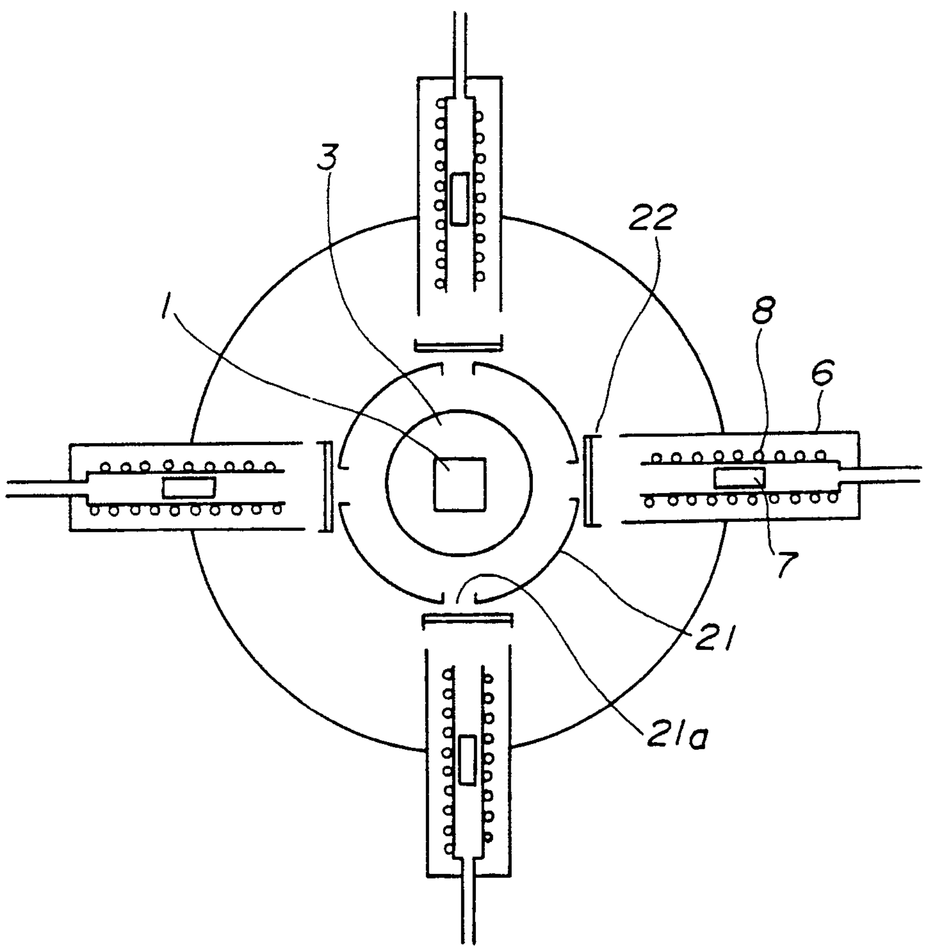

FIG. 19

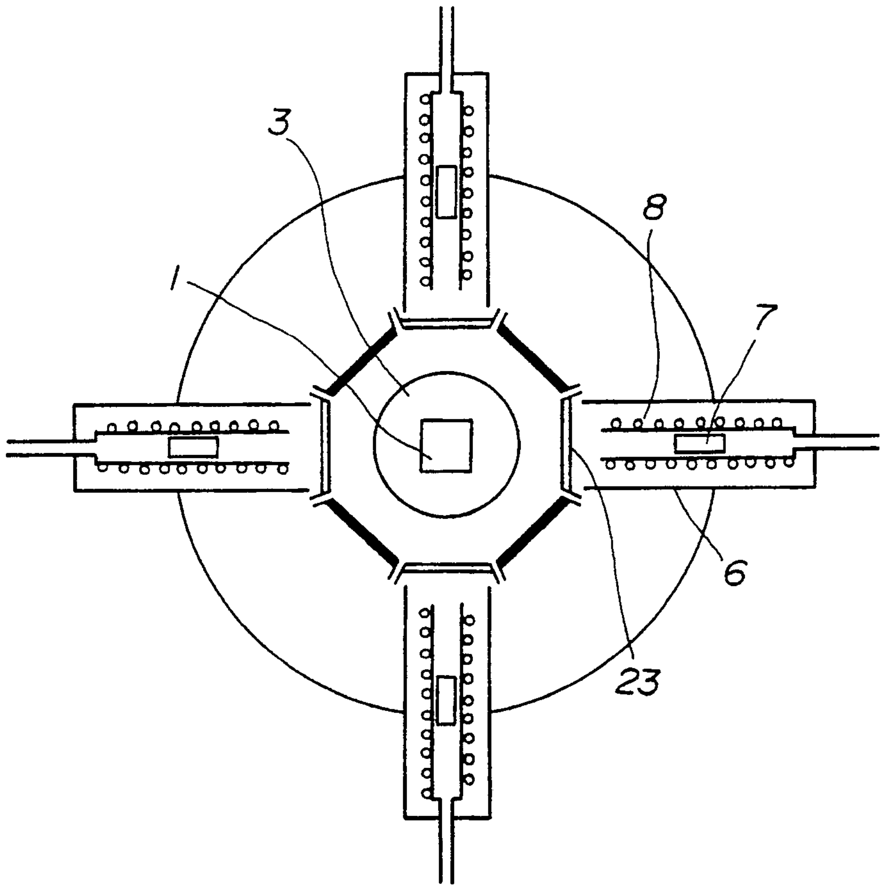

FIG.20

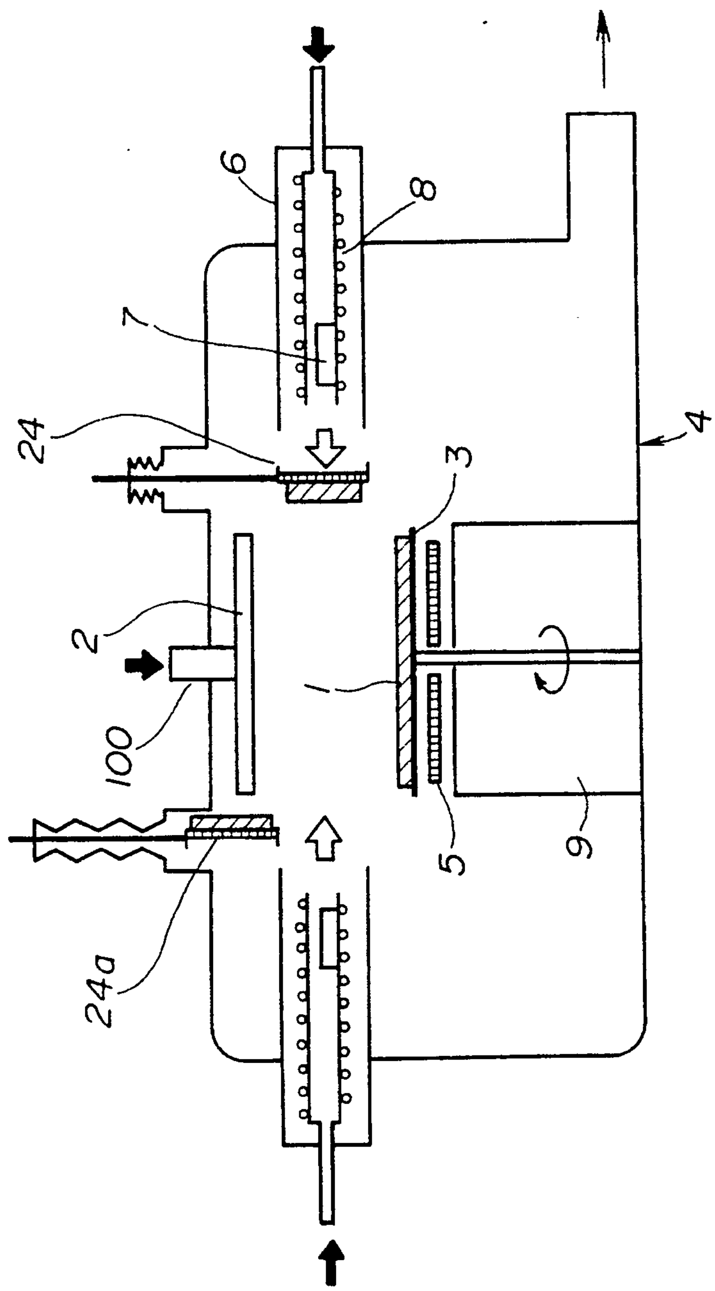

FIG. 21

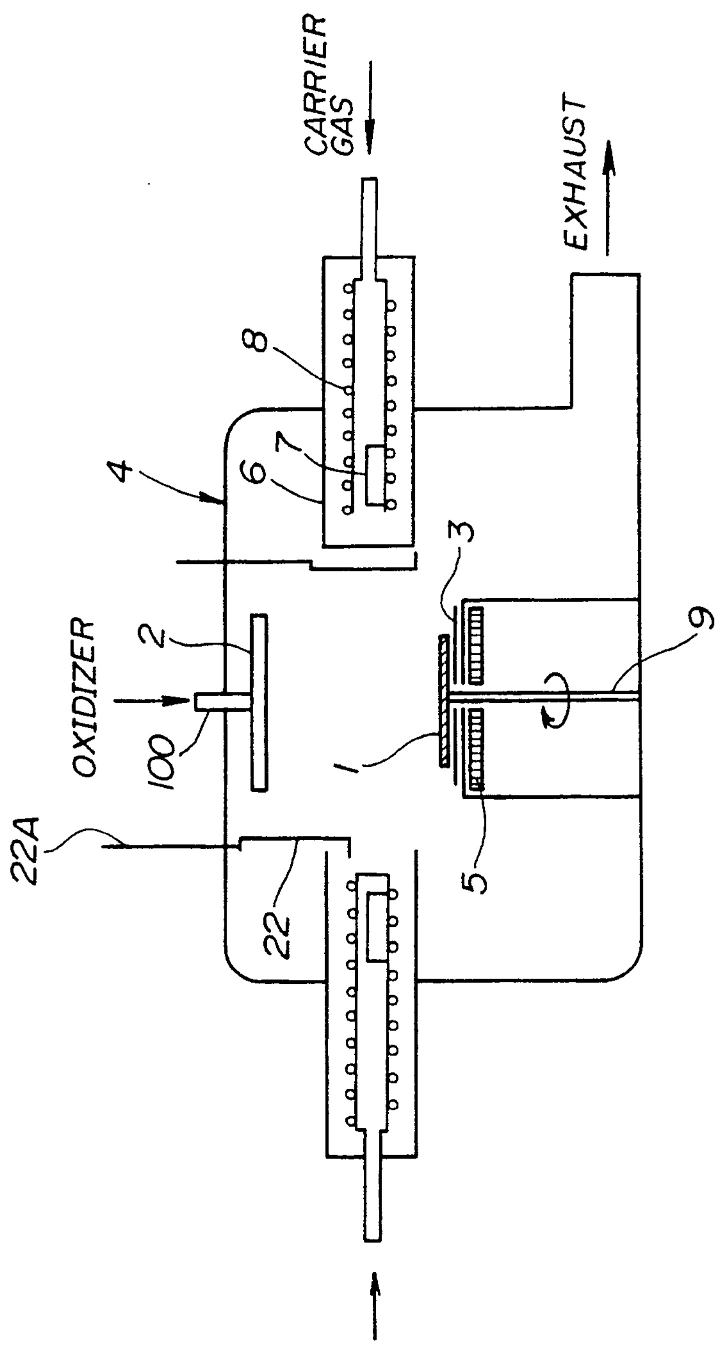

FIG.22

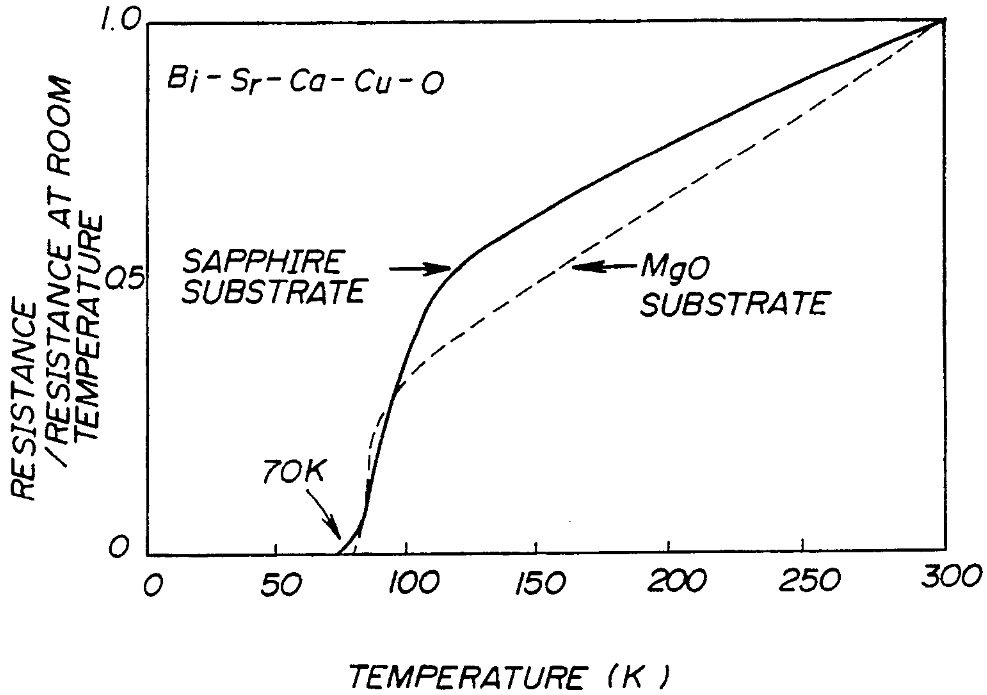
1.0
Bi-Sr-Ca-Cu-O
RESISTANCE /RESISTANCE AT ROOM TEMPERATURE
0.5
SAPPHIRE SUBSTRATE
MgO SUBSTRATE
70K
0
0
50
100
150
200
250
300
TEMPERATURE (K)

FIG. 23

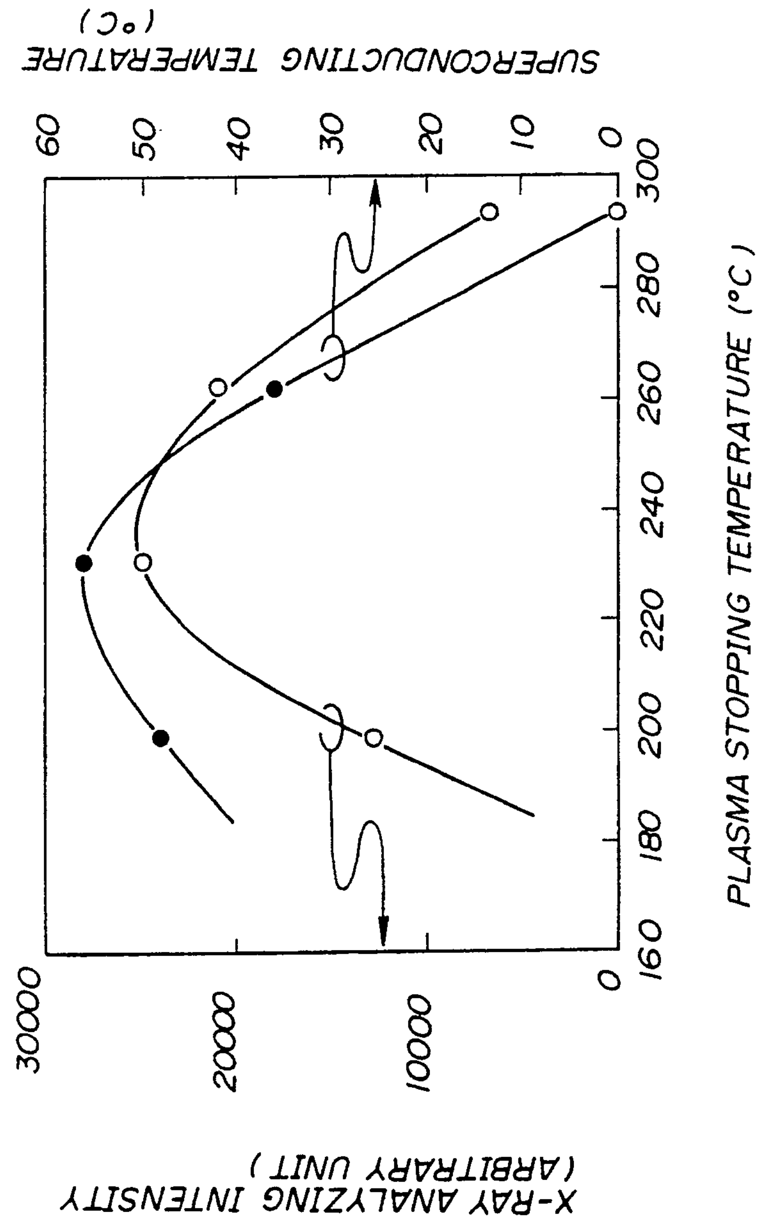
SUPERCONDUCTING TEMPERATURE (°C)
60
50
40
30
20
10
0
X-RAY ANALYZING INTENSITY (ARBITRARY UNIT)
30000
20000
10000
0
160
180
200
220
240
260
280
300
PLASMA STOPPING TEMPERATURE (°C)

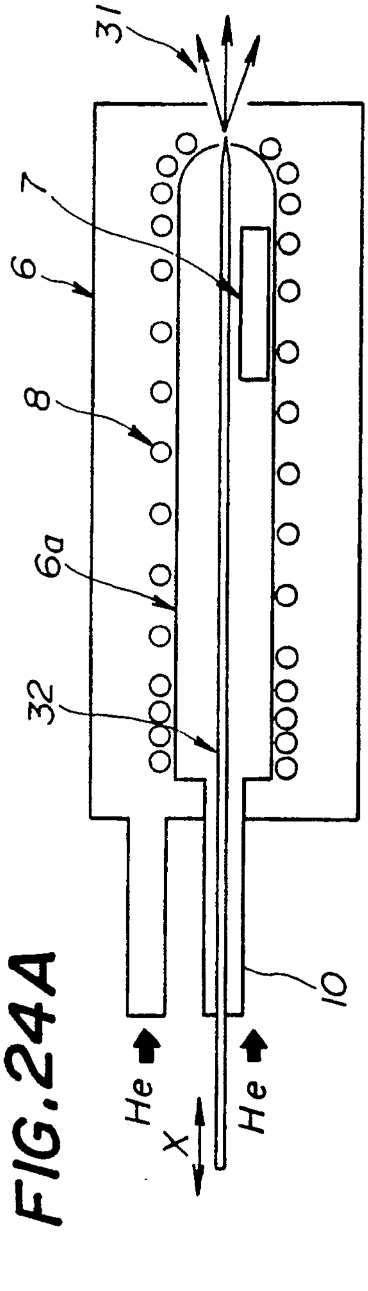


FIG.24A

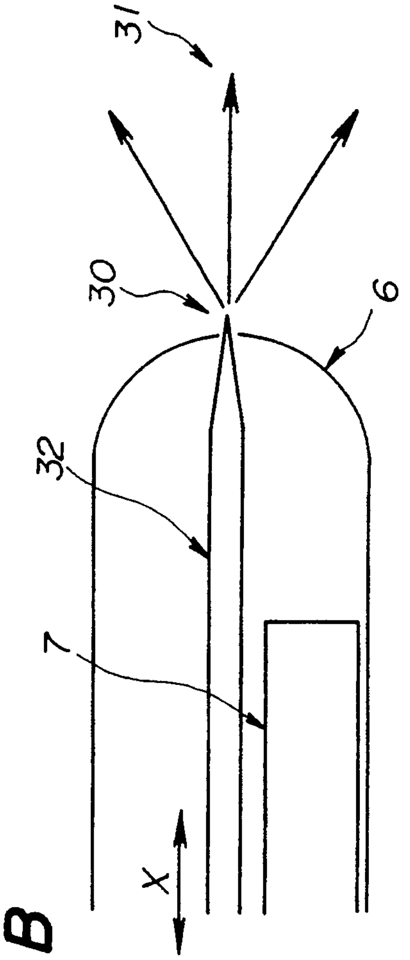


FIG.24B

FIG.25

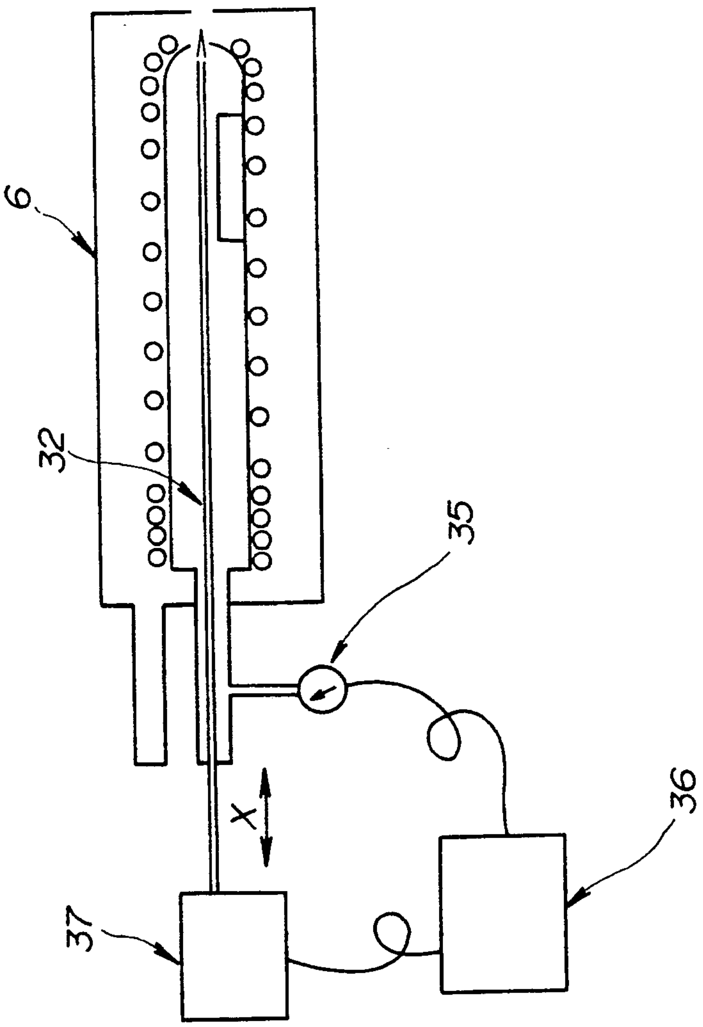

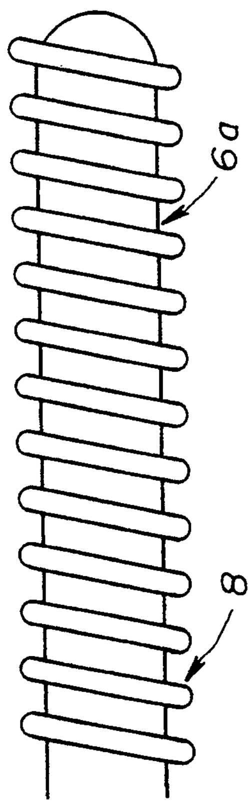


FIG.26A

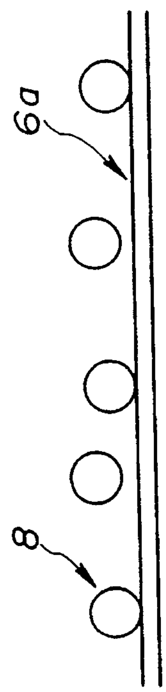


FIG.26B

FIG.27A

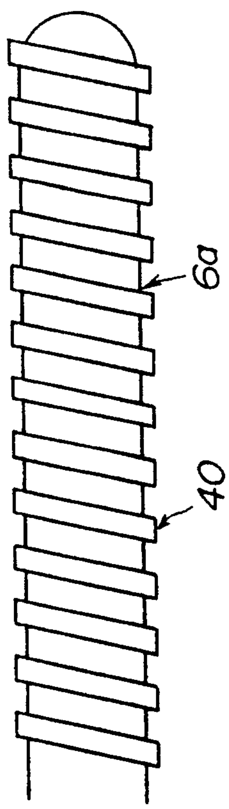


FIG.27B

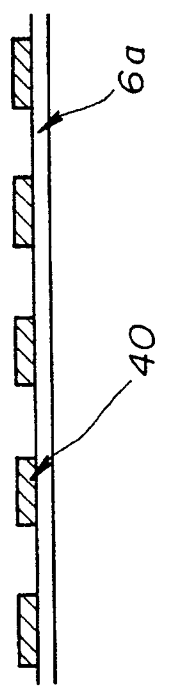

FIG.28A

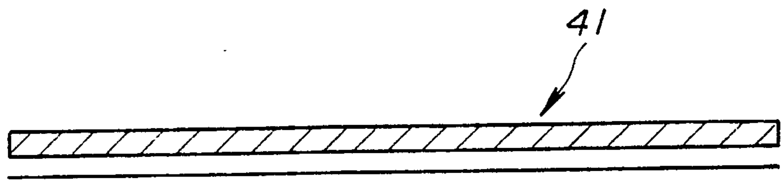


FIG.28B

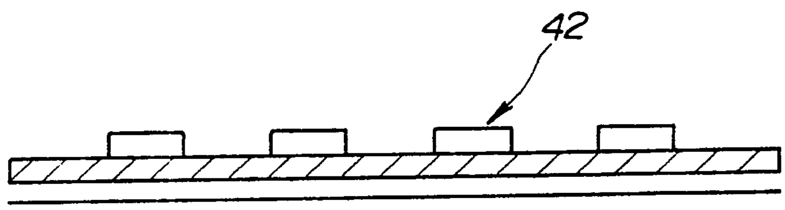


FIG.28C

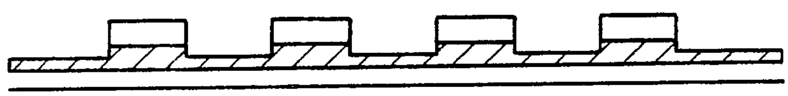

FIG.28D

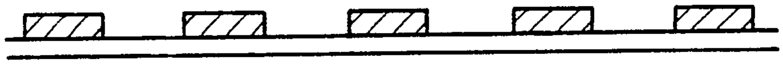

FIG.29A

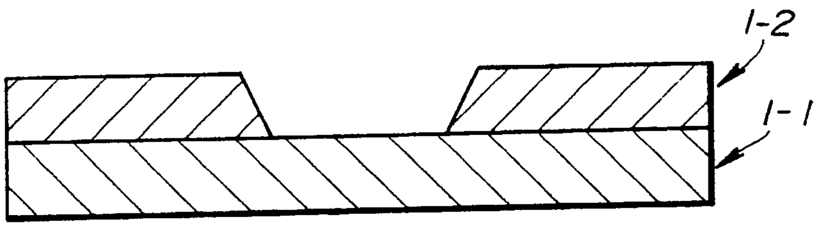


FIG.29B

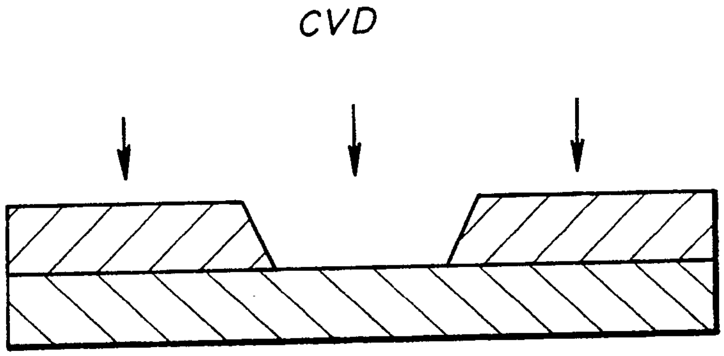


FIG.29C

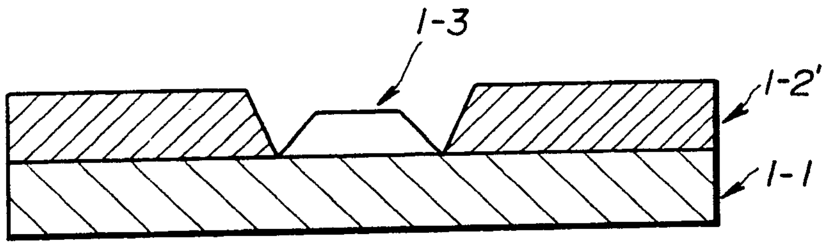

FIG. 30